# EUROPÄISCHE PATENTSCHRIFT

(11) **EP 1 623 471 B1**
(45) Veröffentlichungstag und Bekanntmachung des Hinweises auf die Patenterteilung: **30.05.2007**
(21) Anmeldenummer: 04726999.8
(22) Anmeldetag: 13.04.2004
(51) Int. Cl.: H01L 51/30, C08G 61/10, C08F 2/38

(54) **VERFAHREN ZUR MOLEKULARGEWICHTSKONTROLLE BEI DER SYNTHESE VON POLY(ARYLENVINYLENEN) UND DAMIT HERGESTELLTE POLYMERE**
METHOD FOR CONTROLLING THE MOLECULAR WEIGHT DURING POLY(ARYLENE VINYLENE) SYNTHESIS, AND POLYMERS PRODUCED THEREWITH
PROCEDE DE CONTROLE DU POIDS MOLECULAIRE LORS DE LA SYNTHESE DE POLY(ARYLENE VINYLENES) ET POLYMERES AINSI FABRIQUES

(30) Priorität: 17.04.2003 DE 10318096
(43) Veröffentlichungstag der Anmeldung: 08.02.2006
(73) Patentinhaber: Merck Patent GmbH, 64293 Darmstadt (DE)
(72) Erfinder: SPREITZER, Hubert, 68519 Viernheim (DE); BECKER, Heinrich, 65719 Hofheim (DE); HUFSKY, Elfriede, 60529 Frankfurt (DE)
(86) Internationale Anmeldenummer: PCT/EP2004/003860
(87) Internationale Veröffentlichungsnummer: WO 2004/093209

(56) Entgegenhaltungen:
- US-A- 5 817 430
- R. M. TAYLOR, P.L. BURN, D. D. C. BRADLEY: "Substituted PPV's for blue light" SYNTHETIC METALS, Bd. 102, 1999, Seiten 1120-1121, XP002292788
- YUAN YU, ANITA C. VANLAEKEN, HOOKUN LEE, BING R. HSIEH: "A Modified 1,6-Polymerization Route to Soluble Poly(P-Phenyl Vinylene) Derivatives - Synthesis and Mechanism" POLYMER PREPRINTS, Bd. 39, Nr. 1, 2. März 1998 (1998-03-02), Seiten 161-162, XP009035330 WASHINGTON, DC
- HSIEH B R ET AL: "GENERAL METHODOLOGY TOWARD SOLUBLE POLY(P-PHENYLENEVINYLENE) DERIVATIVES" MACROMOLECULES, AMERICAN CHEMICAL SOCIETY. EASTON, US, Bd. 30, Nr. 25, 15. Dezember 1997 (1997-12-15), Seiten 8094-8095, XP000727550 ISSN: 0024-9297
- BING R. HSIEH, YUAN YU, ERIC W. FORSYTHE, GREGORY M. SCHAAF, WILLIAM A. FELD: "A New Family of Highly Emissive Soluble Poly(p-phenylene vinylene) Derivatives. A Step toward Fully Conjugated Blue-Emitting Poly(p-phenylene vinylenes)" JOURNAL OF THE AMERICAN CHEMICAL SOCIETY, Bd. 120, 1998, Seiten 231-232, XP002292789 in der Anmeldung erwähnt
- HONTIS L ET AL: "The Gilch polymerisation towards OC1C10-PPV: indications for a radical mechanism" 1. Juni 2001 (2001-06-01), POLYMER, ELSEVIER SCIENCE PUBLISHERS B.V, GB, PAGE(S) 5793-5796 , XP004231768 ISSN: 0032-3861 das ganze Dokument

## Beschreibung

Seit ca. 12 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in EP 423 283 (WO 90/13148) offenbart sind. Die einzigen Polymere, die derzeit den Marktanforderungen in Bezug auf Effizienz und Lebensdauer genügen, basieren auf Poly(arylenvinylenen). Seit kurzem ist auch ein erstes Produkt in Form einer kleineren Anzeige in einem Rasierapparat der Fa. PHILIPS N.V. auf dem Markt erhältlich, das ein Polymer dieser Klasse enthält. Allerdings sind immer noch deutliche Verbesserungen nötig, um diese Displays zu einer echten Konkurrenz zu den derzeit marktbeherrschenden Flüssigkristallanzeigen (LCD) zu machen.

In EP 423 283 und EP 443 861 sind als polymere Materialien für die lichtemittierende Schicht Poly(p-phenylenvinylene) beschrieben, welche zur Verbesserung der Eigenschaften mit Alkyl-, Alkoxy-, Halogen- oder Nitrosubstituenten am aromatischen Kern modifiziert wurden. Derartige Polymere sind seither in einer großen Anzahl von Studien untersucht worden.

In WO 98/27136 sind arylsubstituierte Poly(p-arylenvinylene) beschrieben, die sich auch zur Erzeugung grüner Elektrolumineszenz eignen. Eine weitere Verbesserung der dort beschriebenen Polymere geht aus WO 99/24526 hervor. Hier wird auch ein Defekt in derartigen Polymeren offenbart: In der Hauptkette kommen je nach Polymer statt der Doppelbindung variierende Anteile von Dreifach- und Einfachbindungen (TBB-Defekt) vor. Der Anteil dieses Defekts steht offenbar im reziproken Verhältnis zur erzielbaren Lebensdauer: Ein hoher Defektanteil erniedrigt die operative Lebensdauer, ein niedriger Anteil erhöht diese deutlich. In der genannten Anmeldung WO 99/24526 wird offenbart, dass die Defektrate durch das verwendete Substitutionsmuster beeinflusst werden kann, und dass diese Rate ausgehend von arylsubstituierten Monomeren (gemäß WO 98/27136) durch das Einfügen von CN, F, Cl, einer Amino-, Alkyl- oder (Thio)alkoxygruppe deutlich verringert werden kann.

In WO 01/34722 (EP 1232225) wurde offenbart, dass Poly(arylenvinylene), die Monomer-Einheiten enthalten, deren Phenyleneinheit einen weiteren ArylSubstituenten para oder meta zu einem ersten Arylrest trägt, diesen in der o. g. Anmeldung geschilderten Effekt unerwartet ausgeprägt aufweisen. Dadurch kann die operative Lebensdauer in EL-Elementen noch weiter gesteigert werden. Dies ist natürlich von großer Anwendungsrelevanz und wirtschaftlicher Bedeutung. Die hohen EL-Effizienzen bleiben dabei erhalten.

Aus US 5,558,904 sind Polymere analog zu den oben genannten offenbart, bei denen die beiden Substituenten entweder nicht oder nur durch kurzkettige Substituenten (Fluor, Cyano, Methoxy, Phenyl) substituiert sind. Homopolymere bzw. auch Copolymere mit einem Anteil derartiger Strukturen von größer ca. 25 mol% erweisen sich allerdings als unlöslich.

Löslichkeit bzw. Unlöslichkeit im Sinne dieser Anmeldung sei definiert, wie dies auch in WO 99/21936 (Seite 3, Zeilen 2 bis 7) angegeben wird: Der Begriff "lösliches Polymer" bedeutet also, dass dieses im Konzentrationsbereich von mindestens 0,5 Gew.% in einem gebräuchlichen organischen Lösemittel (aromatische, sowie nicht-aromatische Lösemittel, die Halogenatome enthalten können bzw. auch halogenfrei sein können, wie beispielsweise Toluol, Anisol, Chlorbenzol, Methylenchlorid, Chloroform, Xylole, Dioxan, THF, Cyclohexanon u. ä.) eine klare, ungelierte Lösung bei Raumtemperatur oder zumindest bei einer Temperatur unterhalb von 60 °C, bevorzugt unterhalb von 50 °C, besonders bevorzugt unterhalb von 40 °C bildet. Diese Eigenschaft ist notwendig, um eine technische Verarbeitung zu dünnen Filmen gewährleisten zu können. Unlöslich im Sinne dieser Definition sind hingegen Polymere, die nur bei deutlich geringeren Konzentrationen eine klare Lösung ergeben, bzw. die bereits oberhalb von ca. 60 °C gelieren.

Eine besonders geeignete Synthesemethode für Poly(arylenvinylene) ist die sogenannte GILCH-Polymerisation, die ausgehend von 1,4-Bis(halomethyl)benzol, das mit löslichkeitsfördernden Gruppen substituiert ist, baseninduziert zu den gewünschten löslichen Polymeren führt (H. G. Gilch *et al., J*. *Polym. Sci.: A*-*1* **1966**, *4*, 1337). Die dabei intermediär entstehenden Poly(phenylen-haloethylene) werden durch den verwendeten Basenüberschuss direkt in die konjugierten Poly(arylenvinylene) überführt. Eine Optimierung dieser Methode, wie in WO 99/24526 und WO 98/27136 offenbart, führte bereits zu Polymeren mit einer sehr geringen Defektrate und erhöhte die Reproduzierbarkeit der Synthese.

Niedermolekulare Poly(1,4-phenylenvinylen)-Homopolymere und deren Derivate mit sterisch anspruchsvollen Seitenketten wie z. B. tert.-Butyl oder BuPh sind aus R.M. Taylor et al., *Synthetic Metals:* **1999,** 102, 1120-1121 bekannt.

Eine weitere geeignete Synthesemethode ist die Sulfinyl-Precursor-Route, die baseninduzierte Polymerisation von 1-Halomethyl-4-(sulfinylmethyl)arylenen. Diese ist beispielsweise in EP 644217 und EP 705857 und in einer Publikation von A. J. J. M. van Breemen *et al. (Macromolecules* **1999**, *32*, 5728-5735) beschrieben. Die dabei zunächst isolierten Poly(phenylen-sulfinylethylen)-Polymere werden in einem zweiten Schritt thermisch in die konjugierten Poly(arylenvinylene) überführt.

Wie oben bereits angedeutet, ist es für beide Methoden jedoch häufig schwierig, Monomere mit geeigneten Substituenten zu finden, die einerseits zu löslichen Polymeren führen, andererseits aber auch die gewünschten elektronischen und/oder polymerisationstechnisch positiven Eigenschaften aufweisen.

Es zeichnet sich derzeit eine Entwicklung in der Fabrikation von Displays auf Basis lichtemittierender Polymere ab, die zunehmend von den geläufigen Verfahren für Flächenbeschichtungen, beispielsweise durch Spin-Coat-Verfahren oder Rackel-Techniken, abkommt, zugunsten von neuen ortsaufgelösten Druckverfahren im weitesten Sinne, wie beispielsweise Tintenstrahldrucken, Off-Set-Drucken, Screen-Printing-Verfahren, Tiefdruckverfahren und ähnlichen. Hierfür ist es einerseits erforderlich, die Konzentration der Polymerlösung in einem weiten Bereich variieren zu können und sehr genau einzustellen, um beim Drucken die gewünschte Schichtdicke zu erhalten. Also wird es auch hierzu zunehmend wichtig, sehr gut lösliche Polymere zur Verfügung zu haben. Andererseits ist es für diese Techniken ebenfalls essentiell, die Viskosität der Lösung genau einzustellen, um die Druckeigenschaften für den entsprechenden Druckprozess optimieren zu können. Da die Viskosität einer Polymerlösung in etwa proportional zur dritten Potenz des Molekulargewichts des Polymers ist, ist offensichtlich, dass insbesondere hierfür eine genaue und reproduzierbare Kontrolle des Molekulargewichts erforderlich ist. So wird beispielsweise in US 200110003602 beschrieben, dass zum Tintenstrahldrucken von Poly(aryleginylenen) ein Molekulargewicht M_{w} < 600 log.mol⁻¹ (kDa) bevorzugt im Bereich von 20 bis 100 log.mol⁻¹ (kDa), erforderlich ist. WO 02/096970 gibt hierfür einen bevorzugten Molekulargewichtsbereich von Mₙ < 30 log.mol⁻¹ (kDa) und M_{w} < 500 log.mol⁻¹ (kDa) an.

Aus diesem Grund ist es wünschenswert, eine Methode zur Molekulargewichtskontrolle der Polymere zur Verfügung zu haben, um mit einer Vielzahl unterschiedlicher Substituenten reproduzierbar gut lösliche Polymere zu erhalten, die nicht nur für Flächenbeschichtungen, sondern auch für Druckverfahren verwendet werden können.

In US 5,817,430 wird die Synthese von Poly(arylenvinylenen) beschrieben, der im Polymerisationsprozess Verbindungen R-H zugesetzt werden, die die Kettenenden kontrollieren, wobei R-H eine Verbindung darstellt, die mindestens ein saures Proton enthält, und R ein Nucleophil ist. R soll dann die Endgruppen des Polymers bilden. Durch Reduzierung des Molekulargewichts erhält man so lösliche Polymere. In den nachfolgenden Publikationen von Hsieh *et al. (Macromolecules* **1997,** 30, 8094-8095; *J. Am. Chem. Soc.* **1998,** 120, 231-232) und von Ferraris *et al. (Macromolecules* **2000,** 33, 2311) wird diese Methode näher beschrieben: Die Reduzierung des Molekulargewichts wird durch eine Modifikation der GILCH-Polymerisation erzielt, indem der Reaktionsmischung nicht polymerisierbare saure Additive, wie beispielsweise 4-*tert*-Butylbenzylchlorid, 4-*tert*-Butylbenzylbromid oder 4-Methoxyphenol, zugefügt werden. Das Molekulargewicht kann dann angeblich durch Variation des Verhältnisses zwischen den Monomeren und dem nicht polymerisierbaren Additiv gesteuert werden. Allerdings deuteten eigene Versuche darauf hin, dass der Zusatz solcher Additive, wie in US 5,817,430, von Hsieh *et al.* bzw. von Ferraris et al. vorgeschlagen, keinen erheblichen Einfluss auf das Molekulargewicht des Polymers hat. In Folge wurden die Ergebnisse ebenfalls in einer Publikation von Vanderzande *et al. Polymer* **2001**, *42*, 5793-5796) widerlegt, der zeigte, dass die Additive nicht den berichteten Effekt zeigen und dass sie das Molekulargewicht kaum reduzieren bzw. dass der Zusatz dieser Verbindungen zu schlecht reproduzierbaren Polymerisationsergebnissen führt. Diese Ergebnisse sind also selbst für den Fachmann nicht nachvollziehbar, so dass gemäß dem Stand der Technik keine Methode existiert, um das Molekulargewicht von Poly(arylenvinylenen) in der GILCH-Polymerisation oder in der Sulfinyl-Precursor-Route zu kontrollieren und zu reduzieren.

Eine andere Methode, aus schwer löslichen oder nicht filtrierbaren Poly(arylenvinylenen) homogene Lösungen zu erhalten, die problemlos filtriert werden können, wird in WO 03/019694 dargestellt. Dort wird eine Rohlösung mit mechanischen Verfahren (beispielsweise durch Ultraschall oder durch die Verwendung hochscherender Dispergierrührer) behandelt. Dies resultiert in Zerkleinerung der chemischen oder physikalischen Aggregate der Polymerketten und somit Reduktion des Molekulargewichts. Diese Methode kann sehr vorteilhaft verwendet werden, um kleinere Chargenschwankungen in der Synthese auszugleichen und ein reproduzierbares Konzentrations-Viskositäts-Verhältnis zu erreichen. Darüber hinaus kann dieses Verfahren auch zum gezielten stärkeren Molekulargewichtsabbau verwendet werden. Jedoch hat der Einsatz von Ultraschall, insbesondere wenn die Polymerlösung eine längere Zeit dem Ultraschall ausgesetzt ist, auch einen negativen Einfluss auf die Leistungen des Polymers bei Verwendung in PLEDs, so dass dies zwar eine Möglichkeit darstellt, sonst nicht verarbeitbare Poly(arylenvinylene) prozessierbar zu machen, jedoch auf Dauer eine schonendere Lösung zur Molekulargewichtskontrolle wünschenswert wäre.

Es besteht also weiterhin großer Bedarf nach einem Verfahren, das es ermöglicht, das Molekulargewicht von Poly(arylenvinylenen) in der GILCH-Polymerisation und in der Sulfinyl-Precursor-Polymerisation zu kontrollieren und zu reduzieren, um andere Strukturen zugänglich zu machen, die sonst zu unlöslichem Material geführt hätten, und um die Eigenschaften dieser wichtigen Materialklasse auch für moderne Drucktechniken anzupassen.

Überraschend wurde nun gefunden, dass der Zusatz bestimmter substituierter Bismethylaryl-Verbindungen, die an mindestens einer der beiden Methylgruppen eine Abgangsgruppe, wie beispielsweise ein Halogenatom oder eine Trifluormethansulfonatgruppe, und außerdem noch an jeder der beiden Methylgruppen einen weiteren Substituenten ungleich Wasserstoff tragen, zum Polymerisationprozess es ermöglicht, das Molekulargewicht von Poly(arylenvinylenen) in der GILCH-Polymerisation und in der Sulfinyl-Precursor-Polymerisation effektiv und reproduzierbar zu kontrollieren und zu reduzieren. Dabei bleiben die Eigenschaften der Polymere bei Verwendung in PLEDs (Effizienz, Lebensdauer) unverändert gut.

Gegenstand der Erfindung ist also ein Verfahren zur baseninduzierten Herstellung von Poly(arylenvinylenen) aus Bis(halomethyl)arylen oder aus Halomethyl-sulfinylmethylarylen, dadurch gekennzeichnet, dass die Umsetzung in Gegenwart von 0,1 - 80 mol%, bevorzugt 0,5 - 60 mol%, besonders bevorzugt 1 - 50 mol%, insbesondere 2 - 40 mol%, einer oder mehrerer Verbindungen gemäß Formel (I) durchgeführt wird: 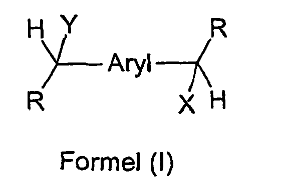 wobei die Symbole folgende Bedeutungen haben:
- Aryl: ist bei jedem Auftreten gleich oder verschieden ein bivalentes aromatisches oder heteroaromatisches Ringsystem mit 2 bis 40 C-Atomen, welches mit Resten R¹ substituiert oder auch unsubstituiert sein kann, oder eine mit R¹ substituierte oder unsubstituierte Stilbenyleneinheit; dabei sind die beiden Substituenten CHXR und CHYR so angeordnet, dass eine gerade Anzahl von aromatischen Atomen dazwischen liegt; die Aryl- und Heteroaryl-Systeme können dabei auch Teil eines größeren kondensierten aromatischen Ringsystems sein; die möglichen Substituenten R¹ können potenziell an jeder freien Position sitzen;
- R: ist bei jedem Auftreten gleich oder verschieden eine Alkylkette mit 1 bis 40 C-Atomen, die geradkettig, verzweigt oder cyclisch sein kann, die außerdem mit einem oder mehreren Resten R¹ substituiert oder unsubstituiert sein kann, in der auch ein oder mehrere nicht benachbarte C-Atome durch -CR²=CR²-, -C≡C-, -NR²-, -O-, -S-, -CO-, -CO-O-, -CONR²-, -O-CO-O- ersetzt sein können, wobei auch ein oder mehrere H-Atome durch Fluor ersetzt sein können, ein aromatisches oder heteroaromatisches Ringsystem mit 2 bis 40 C-Atomen, welches mit R¹ substituiert oder unsubstituiert sein kann, eine mit R¹ substituierte oder unsubstituierte Stilbenyl- bzw. Tolanyleinheit, eine Gruppe -Si(R²)₃, -N(R²)₂, -OR² oder eine Kombination dieser Systeme; die Aryl- und Heteroaryl-Systeme können dabei auch Teil eines größeren kondensierten aromatischen Ringsystems sein; die möglichen Substituenten R¹ können potenziell an jeder freien Position sitzen;
- X: ist bei jedem Auftreten gleich oder verschieden Cl, Br, I, Trifluormethansulfonat oder Arylsulfonat;
- Y: ist bei jedem Auftreten gleich oder verschieden Cl, Br, I, Trifluormethansulfonat, Arylulfonat, -S(O)R² oder R¹;
- R¹: ist bei jedem Auftreten gleich oder verschieden eine geradkettige, verzweigte oder cyclische Alkylkette mit 1 bis 40 C-Atomen, in der auch ein oder mehrere nicht benachbarte C-Atome durch -CR²=CR²-, -C≡C-, -NR²-, -O-, -S-, -CO-, -CO-O-, -CONR²-, -O-CO-O- ersetzt sein können, wobei auch ein oder mehrere H-Atome durch Fluor ersetzt sein können, ein aromatisches oder heteroaromatisches Ringsystem mit 2 bis 40 C-Atomen, welches auch durch ein oder mehrere nicht-aromatische Reste R¹ substituiert sein kann, eine substituierte oder unsubstituierte Vinylgruppe, Cl, F, CN, N(R²)₂, B(R²)₂ oder eine Kombination dieser Systeme; die Aryl- und Heteroaryl-Systeme können dabei auch Teil eines größeren kondensierten aromatischen Ringsystems sein; die möglichen Substituenten können potenziell an jeder freien Position sitzen; dabei können auch zwei oder mehrere Reste R¹ miteinander ein Ringsystem bilden;
- R²: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch -O-, -S-, -CO-O-, -O-CO-O- ersetzt sein können, wobei auch ein oder mehrere H-Atome durch Fluor ersetzt sein können, ein Aryl- oder Heteroaryl-System mit 2 bis 40 C-Atomen, welches auch durch ein oder mehrere nicht-aromatische R¹ substituiert sein kann.

Dabei sind die Monomere bevorzugt Verbindungen gemäß Formel (XXVI), 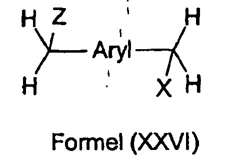 wobei Aryl, R¹ und R² dieselbe Bedeutung haben, wie oben unter Formel (I) beschrieben und für die weiteren verwendeten Symbole gilt:
- X: ist bei jedem Auftreten gleich oder verschieden Cl, Br, I, Trifluormethansulfonat oder Arylsulfonat;
- Z: ist bei jedem Auftreten gleich oder verschieden Cl, Br, I, Trifluonnethansulfonat, Arylsulfonat oder -S(O)R².

Dabei ist für das GILCH-Verfahren X und Z bevorzugt Cl, Br oder l. Für das Sulfinyl-Precursor-Verfahren ist X bevorzugt Cl, Br oder l und Z ist -S(O)R².

Für das GILCH-Verfahren werden die Monomere, also 1,4-Bis(halomethyl)aryl-Verbindungen, im gewünschten Verhältnis zueinander in geeigneter Konzentration In einem geeigneten Lösungsmittel unter Zusatz einer geeigneten Menge Verbindung gemäß Formel (I) gelöst, auf eine geeignete Reaktionstemperatur gebracht und mit einer geeigneten Menge Base versetzt. Nach Ablauf einer geeigneten Reaktionszeit kann die Reaktion, zum Beispiel durch Säurezugabe, abgebrochen werden. Im Anschluss daran reinigt man das Polymer mit geeigneten, dem Fachmann geläufigen Verfahren, wie z. B. Umfällen oder Extraktion. Geeignete Lösungsmittel stellen beispielsweise Ether (z. B. Diethylether, THF, Dioxan, Dioxolan, *tert*-Butylmethylether), aromatische Kohlenwasserstoffe (z. B.

Toluol, Xylole, Anisol, Methylnaphthalin), chlorierte Verbindungen (z. B. Chlorbenzol, Dichlorbenzol) oder Mischungen dieser Lösungsmittel dar.
Einen geeigneten Konzentrationsbereich stellt dabei das Intervall 0,005 bis 5 mol/l (Monomer/Lösungsvolumen) dar. Bevorzugt ist dabei der Bereich 0,01 bis 2 mol/l, besonders bevorzugt von 0,01 bis 0,5 mol/l.
Die Reaktionstemperatur beträgt in der Regel zwischen -80 bis 200 °C, bevorzugt zwischen 20 und 140 °C.
Als Basen sind beispielsweise Alkalimetallhydroxide (z. B. NaOH, KOH), Alkalimetallhydride (z. B. NaH, KH), Alkalimetallalkoholate (z. B. NaOEt, KOEt, NaOMe, KOMe, KO*^{t}*Bu), Metallorganyle (z. B. MeLi, *ⁿ*BuLi, *^{s}*BuLi, *^{t}*BuLi, PhLi) und organische Amine und Amide (z. B. LDA, DBU, DMAP, Pyridin) geeignet.
Eine geeignete Menge Base liegt im Bereich von 2 bis 10 Äquivalenten Base (bezogen auf ein Äquivalent Monomer), bevorzugt 3,5 bis 8 Äquivalente Base, besonders bevorzugt 4 bis 6 Äquivalente Base.
Die Reaktionszeit beträgt in der Regel zwischen 5 Minuten und 72 h, bevorzugt zwischen 0,5 und 24 h, besonders bevorzugt zwischen 1 und 6 h.
Der Zusatz an Verbindung gemäß Formel (I) zur Molekulargewichtskontrolle beträgt zwischen 0,1 und 80 mol% (bezogen auf die Gesamtmenge der anderen Monomere), bevorzugt zwischen 0,5 und 60 mol%, besonders bevorzugt zwischen 1 und 50 mol%, insbesondere zwischen 2 und 40 mol%, und wird je nach dem gewünschten Molekulargewicht des Polymers ausgewählt.

Für die Sulfinyl-Precursor-Route werden die Monomere, also 1-Halomethyl-4-sulfinylmethyl-aryl-Verbindungen, im gewünschten Verhältnis zueinander in geeigneter Konzentration in einem geeigneten Lösungsmittel unter Zusatz einer geeigneten Menge Verbindung gemäß Formel (I) gelöst, auf eine geeignete Reaktionstemperatur gebracht und mit einer geeigneten Menge Base versetzt. Nach Ablauf einer geeigneten Reaktionszeit kann die Reaktion, zum Beispiel durch Säurezugabe, abgebrochen werden. Im Anschluss daran reinigt man das Precursor-Polymer mit geeigneten, dem Fachmann geläufigen Verfahren, wie z. B. Umfällen oder Extraktion. Die Poly(arylenvinylen)-Verbindung wird dann durch thermische Einwirkung auf das Polymer unter geeigneten Bedingungen, in Lösung oder im Film, erhalten.
Geeignete Lösungsmittel stellen beispielsweise Ether (z. B. Diethylether, THF, Dioxan, Dioxolan, terf-Butylmethylether), aromatische Kohlenwasserstoffe (z. B. Toluol, Xylole, Anisol, Methylnaphthalin), chlorierte Verbindungen (z. B. Chlorbenzol, Dichlorbenzol, Dichlormethan), aber auch DMSO oder protische Lösungsmittel (z. B.

MeOH, EtOH, *ⁿ*PrOH, *ⁿ*BuOH, *ⁿ*PeOH, *ⁱ*PrOH, *^{s}*BuOH, *^{s}*PeOH, *^{tert}*BuOH) oder Mischungen dieser Lösungsmittel dar.
Einen geeigneten Konzentrationsbereich stellt dabei das Intervall 0,005 bis 5 mol/l (Monomer/Lösungsvolumen) dar. Bevorzugt ist dabei der Bereich 0,01 bis 2 mol/l, ganz besonders bevorzugt von 0,01 bis 0,5 mol/l.
Die Reaktionstemperatur beträgt in der Regel zwischen -80 bis 200°C, bevorzugt zwischen 0 und 120 °C.
Als Basen sind beispielsweise Alkalimetallhydroxide (z. B. NaOH, KOH), Alkalimetallalkoholate (z. B. NaOEt, KOEt, NaOMe, KOMe, KOBu) und organische Amine und Amide (z. B. LDA, DBU, DMAP, Pyridin) geeignet, aber auch Alkalimetallhydride (z. B. NaH, KH), wenn nicht-protische Lösungsmittel verwendet werden, oder Metallorganyle (z. B. MeLi, *ⁿ*BuLi, *^{s}*BuLi, *^{t}*BuLi, PhLi), wenn nicht-protische Lösungsmittel und kein DMSO verwendet wird.
Eine geeignete Menge liegt dabei im Bereich von 1 bis 20 Äquivalenten Base (bezogen auf ein Äquivalent Monomer), bevorzugt 1 bis 10 Äquivalente Base, besonders bevorzugt 1 bis 5 Äquivalente Base.
Die Reaktionszeit beträgt in der Regel zwischen 5 Minuten und 72 h, bevorzugt zwischen 0,5 und 6 h, ganz besonders bevorzugt zwischen 1 und 4 h.
Der Zusatz an Verbindung gemäß Formel (I) zur Molekulargewichtskontrolle beträgt zwischen 0,1 und 80 mol% (bezogen auf die Gesamtmenge der restlichen Monomere), bevorzugt zwischen 0,5 und 60 mol%, besonders bevorzugt zwischen 1 und 50 mol%, insbesondere zwischen 2 und 40 mol%, und wird je nach dem gewünschten Molekulargewicht des Polymers ausgewählt.
Das Poly(arylenethylen)-Precursor-Polymer wird durch thermische Behandlung in das konjugierte Poly(arylenvinylen) umgewandelt. Eine geeignete Temperatur hierfür ist 50 bis 250 °C, bevorzugt 80 bis 200 °C, besonders bevorzugt 100 bis 150 °C, wobei die Umwandlung sowohl in Lösung, als auch im Film durchgeführt werden kann.

Dabei ist es bevorzugt, Verbindungen gemäß Formel (I) zu wählen, wobei für die Symbole gilt:
- Aryl: ist gleich oder verschieden ein bivalentes aromatisches Ringsystem mit 2 bis 40 C-Atomen, welches mit bis zu 4 Substituenten R¹ substituiert oder auch unsubstituiert sein kann, oder eine mit R¹ substituierte oder unsubstituierte Stilbenyleneinheit; dabei sind die beiden Substituenten CHXR und CHYR so angeordnet, dass eine gerade Anzahl aromatischer Atome dazwischen liegt; das Arylsystem kann dabei auch Teil eines größeren kondensierten aromatischen R Ringsystems sein; die möglichen Substituenten R¹ können dabei potenziell an jeder freien Position sitzen;
- R: ist wie oben definiert;
- X: ist bei jedem Auftreten gleich oder verschieden Cl, Br, l;
- Y: ist wie oben definiert;
- R¹, R²: sind wie oben definiert.

Besonders bevorzugt sind hierbei Verbindungen gemäß Formel (I), für die gilt:
- Aryl: ist gleich oder verschieden ein bivalentes aromatisches Ringsystem mit 2 bis 20 C-Atomen, welches mit 0 bis 4 Substituenten R¹ substituiert oder auch unsubstituiert sein kann, oder eine mit R¹ substituierte oder unsubstituierte Stilbenyleneinheit; dabei sind die beiden Substituenten CHXR und CHYR so angeordnet, dass die Anzahl der aromatischen Atome der dazwischen liegenden Aryleinheit ein Vielfaches von 4 beträgt; das Arylsystem kann dabei auch Teil eines größeren kondensierten aromatischen Ringsystems sein; die möglichen Substituenten R¹ können dabei potenziell an jeder freien Position sitzen;
- R: ist bei jedem Auftreten gleich oder verschieden eine Alkylkette mit 1 bis 20 C-Atomen, wobei das C-Atom, mit dem es an die CHX-Gruppe bzw. CHY-Gruppe verknüpft ist, keine H-Atome trägt und die ansonsten geradkettig, verzweigt oder cyclisch sein kann, die außerdem mit R¹ substituiert oder unsubstituiert sein kann, in der auch ein oder mehrere nicht benachbarte C-Atome durch -CF²=CR²-, -C≡C-, -NR²-, -O-, -S-, -CO-, -CO-O-, -CONR²-, -O-CO-O- ersetzt sein können, wobei auch ein oder mehrere H-Atome durch Fluor ersetzt sein können, ein aromatisches oder heteroaromatisches Ringsystem mit 2 bis 20 C-Atomen, welches auch durch ein oder mehrere nicht-aromatische Gruppen R¹ substituiert sein kann oder -Si(R³)₃, -N(R²)₂, -OR²; die Aryl- und Heteroaryl-Systeme können dabei auch Teil eines größeren kondensierten aromatischen Ringsystems sein; die möglichen Substituenten können potenziell an jeder freien Position sitzen;
- X: ist bei jedem Auftreten gleich oder verschieden Cl oder Br;
- Y: ist bei jedem Auftreten gleich oder verschieden Cl, Br oder -S(O)R²;
- R¹, R²: sind wie oben definiert.

Einige besonders bevorzugte Verbindungen gemäß Formel (I) sind die im Folgenden abgebildeten Formeln (II) bis (XXV), wobei mögliche Substituenten der Übersicht halber meist nicht abgebildet sind:

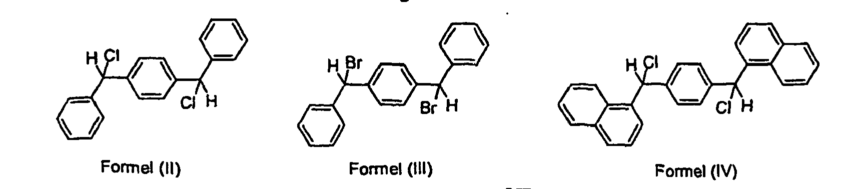

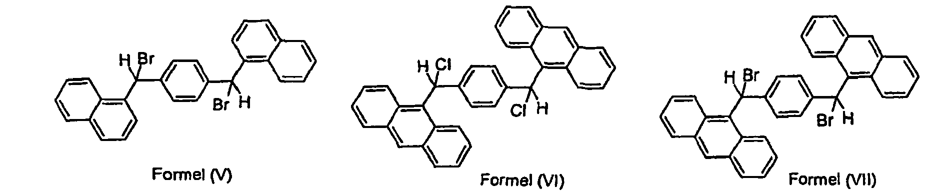

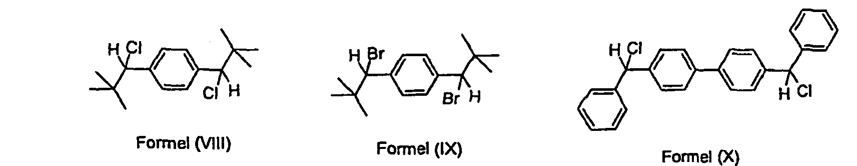

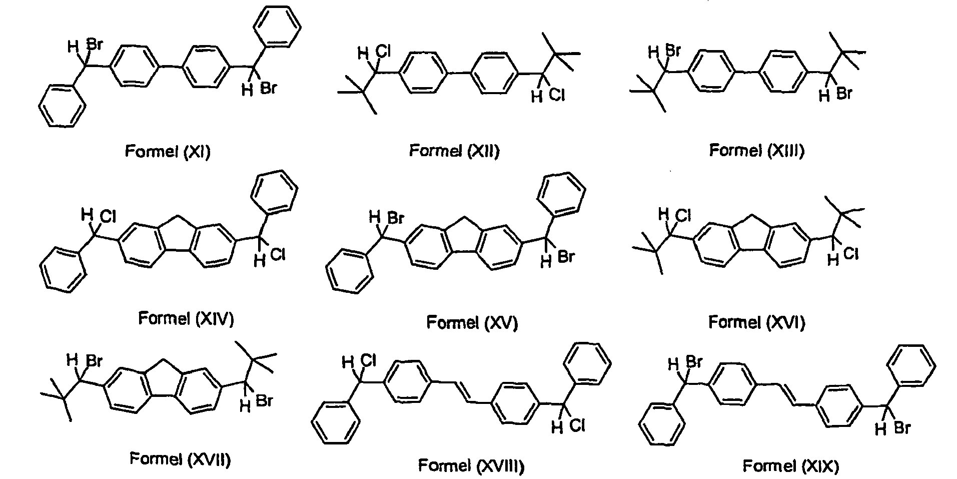

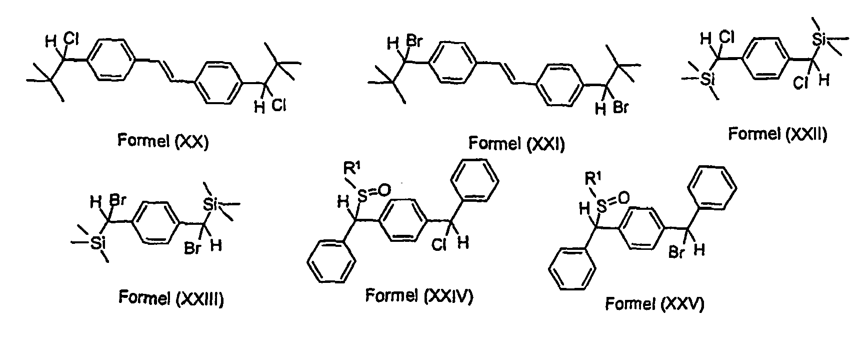

Die Verbindung der Formel (I) wird bei der Polymerisation in das gebildete Poly(arylenvinylen) eingebaut. Der Einbau kann in die Polymerkette erfolgen oder als Polymerketten-Endgruppe.

Um zu untersuchen, welcher Anteil tatsächlich inkorporiert wird und ob der Einbau nur an den Kettenenden oder auch innerhalb der Kette stattfindet, wurde ein Molekül synthetisiert, das an den aromatischen Resten R mit jeweils einer CF₃-Gruppe substituiert ist (siehe Beispiel 3: **EZ3**). Diese Verbindung wurde einer Polymerisation zugesetzt (siehe Beispiel 8: Polymer **P4**), und das erhaltene Polymer wurde ¹⁹F-NMR-spektroskopisch untersucht. Durch Zusatz von Trifluortoluol als internen Standard und Integration über die Signale konnte dabei gezeigt werden, dass der Zusatz auch in die Kette und nicht nur an die Kettenenden eingebaut wird, da der Fluorgehalt des Polymers höher war als erwartet für ein Polymer, das den Zusatz nur an den Kettenenden enthalten würde.

Poly(arylenvinylene), die durch baseninduzierte Polymerisation von Bis(halomethyl)arylen oder aus Halomethyl-sulfinylmethylarylen in Gegenwart von 0,1 - 80 mol%, bevorzugt 0,5 - 60 mol%, besonders bevorzugt 1 - 50 mol%, insbesondere 2 - 40 mol%, an Verbindungen gemäß Formel (I) hergestellt werden, sind ebenfalls neu und erfinderisch. Durch den Einbau der Verbindung der Formel (I) in die Polymer-Hauptkette oder als Polymer-Endgruppe sind diese Einheiten gemäß Formel (I) im Endprodukt enthalten.

Gegenstand der Erfindung sind somit ebenfalls Poly(arylenvinylene) enthaltend mindestens 0,1 mol% Einheiten gemäß Formel (Ia) und/oder (Ib), 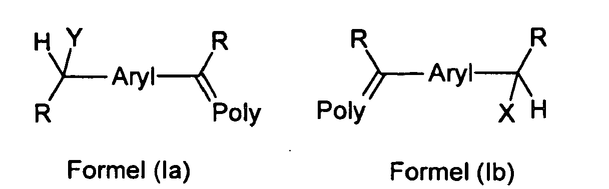 erhältlich aus Bis(halomethyl)arylenen oder Halomethyl-sulfinylmethyl-arylenen durch baseninduzierte Dehydrohalogenierung, dadurch gekennzeichnet, dass die Umsetzung durch Polymerisation von Monomeren gemäß Formel (XXVI) 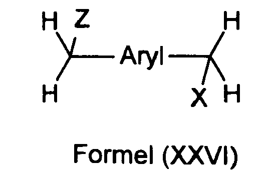 in Gegenwart von 0,1-80 mol% einer oder mehrerer Verbindungen gemäß Formel (I) durchgeführt wird: 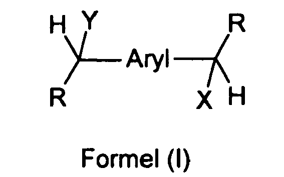 wobei die Symbole in Formeln (I), (Ia), (Ib) und (XXVI) die folgenden Bedeutungen haben:
- Aryl: ist bei jedem Auftreten gleich oder verschieden ein bivalentes aromatisches oder heteroaromatisches Ringsystem mit 2 bis 40 C-Atomen, welches mit Resten R¹ substituiert oder auch unsubstituiert sein kann, oder eine mit R¹ substituierte oder unsubstituierte Stilbenyleneinheit; dabei sind die beiden Substituenten CHXR und CHYR so angeordnet, dass eine gerade Anzahl aromatischer Atome dazwischen liegt; die Aryl- und Heteroaryl-Systeme können dabei auch Teil eines größeren kondensierten aromatischen Ringsystems sein; die möglichen Substituenten R¹ können potenziell an jeder freien Position sitzen;
- R: ist bei jedem Auftreten gleich oder verschieden eine Alkylkette mit 1 bis 40 C-Atomen, die geradkettig, verzweigt oder cyclisch sein kann, die außerdem mit einem oder mehreren Resten R¹ substituiert oder unsubstituiert sein kann, in der auch ein oder mehrere nicht benachbarte C-Atome durch -CR²=CR²-, -C≡C-, -NR²-, -O-, -S-, -CO-, -CO-O-, -CONR²-, -O-CO-O- ersetzt sein können, wobei auch ein oder mehrere H-Atome durch Fluor ersetzt sein können, ein aromatisches oder heteroaromatisches Ringsystem mit 2 bis 40 C-Atomen, welches mit R¹ substituiert oder unsubstituiert sein kann, eine mit R¹ substituierte oder unsubstituierte Stilbenyl- bzw. Tolanyleinheit, -Si(R²)₃, -N(R²)₂, -OR² oder eine Kombination dieser Systeme; die Aryl- und Heteroaryl-Systeme können dabei auch Teil eines größeren kondensierten aromatischen Ringsystems sein; die möglichen Substituenten können potenziell an jeder freien Position sitzen;
- X: ist bei jedem Auftreten gleich oder verschieden Cl, Br, I, Trifluormethan-sulfonat oder Arylsulfonat;
- Y: ist bei jedem Auftreten gleich oder verschieden Cl, Br, l, Trifluormethan-sulfonat, Arylsulfonat, -S(O)-R² oder R¹;
- Z: ist bei jedem Auftreten gleich oder verschieden Cl, Br, l, Trifluormethansulfonat, Arylsulfonat oder -S(O)R²;
- R¹: ist bei jedem Auftreten gleich oder verschieden eine geradkettige, verzweigte oder cyclische Alkylkette mit 1 bis 40 C-Atomen, in der auch ein oder mehrere nicht benachbarte C-Atome durch -CR²=CR²-, -C≡C-, -NR²-, -O-, -S-, -CO-, -CO-O-, -CONR²-, -O-CO-O- ersetzt sein können, wobei auch ein oder mehrere H-Atome durch Fluor ersetzt sein können, ein aromatisches oder heteroaromatisches Ringsystem mit 2 bis 40 C-Atomen, welches auch durch ein oder mehrere nicht-aromatische Reste R¹ substituiert sein kann, eine substituierte oder unsubstituierte Vinylgruppe oder Cl, F, CN, N(R²)₂, B(R²)₂; die Aryl- und Heteroaryl-Systeme können dabei auch Teil eines größeren kondensierten aromatischen Ringsystems sein; die möglichen Substituenten können potenziell an jeder freien Position sitzen; dabei können auch zwei oder mehrere Reste R¹ miteinander ein Ringsystem bilden;
- R²: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch -O-, -S-, -CO-O-, -O-CO-O- ersetzt sein können, wobei auch ein oder mehrere H-Atome durch Fluor ersetzt sein können, ein Aryl- oder Heteroaryl-System mit 2 bis 40 C-Atomen, welches auch durch ein oder mehrere nicht-aromatische R¹ substituiert sein kann; und
- Poly: für eine Anbindung zu einer Poly(arylenvinylen)-Hauptkette steht.

Die mittels des erfindungsgemäßen Verfahrens hergestellten Poly(arylenvinylene) zeigen vergleichbare oder verbesserte elektronische Eigenschaften, wie Lebensdauer und Effizienz, sind aber deutlich besser löslich als Poly(arylenvinylene) gemäß Stand der Technik.

Die so erhaltenen Poly(arylenvinylene) können in PLEDs verwendet werden. Dazu wird in der Regel folgendes allgemeine Verfahren verwendet, das entsprechend für den Einzelfall anzupassen ist:
- Ein Substrat (z. B. Glas oder auch ein Kunststoff, wie speziell behandeltes PET) wird mit einem transparenten Anodenmaterial beschichtet (beispielsweise Indium-Zinn-Oxid, ITO); anschließend wird die Anode (z. B. photolithografisch) der gewünschten Anwendung gemäß strukturiert und verschaltet. Das ganze Substrat und die entsprechende Verschaltung kann hier auch zunächst über einen recht aufwändigen Prozess erzeugt werden, um dadurch eine so genannte Aktiv-Matrix-Steuerung zu ermöglichen.
- Anschließend wird entweder vollflächig oder nur auf die aktiven (= anodischen) Stellen i. d. R. zunächst ein leitfähiges Polymer, z. B. ein dotiertes Polythiophen- oder Polyanilinderivat, aufgebracht. Dies erfolgt in aller Regel durch Beschichtungsverfahren, welche eine Dispersion des entsprechenden Polymers aufbringen. Hierzu eignen sich prinzipiell die weiter unten für das lichtemittierende Polymer beschriebenen Verfahren. Die Schichtdicke dieser Polymerzwischenschicht kann in weiten Bereichen variieren, wird aber für die praktische Anwendung im Bereich zwischen 10 und 1000 nm, bevorzugt zwischen 20 und 500 nm liegen.
- Darauf bringt man dann eine Lösung eines Poly(arylenvinylens) auf, das durch das erfindungsgemäße Verfahren erhalten wurde. Für mehrfarbige Anzeigeelemente (Displays) werden dann mehrere verschiedene Lösungen in verschiedenen Regionen aufgebracht, um entsprechende Farben zu erzeugen. Die Poly(arylenvinylene) werden dazu zunächst in einem geeigneten Lösemittel oder Lösemittelgemisch gelöst und anschließend filtriert. Da die organischen Polymere und v. a. die Zwischenschichten (Interface) in der PLED teilweise extrem durch Sauerstoff oder andere Luftbestandteile beeinflusst werden, empfiehlt es sich, diese Operation unter Schutzgas durchzuführen. Als Lösemittel eignen sich aromatische Lösemittel, wie beispielsweise Toluol, Xylole, Anisol, Chlorbenzol, aber auch andere, wie beispielsweise cyclische Ether (z. B. Dioxan, Methyldioxan) oder auch Amide (z. B. NMP oder DMF), aber auch Lösemittelgemische, wie diese in der Anmeldeschrift WO 02/072714 beschrieben werden.
   Mit diesen Lösungen können die vorher beschriebenen Träger beschichtet werden, und zwar entweder ganzflächig, z. B. durch Spin-Coat-Verfahren oder Rackel-Techniken, oder auch ortsaufgelöst durch Druckverfahren im weitesten Sinne, wie Tintenstrahldrucken, Off-Set-Drucken, Screen-Printing-Verfahren, Tiefdruckverfahren und ähnlichen.
- Auf diese Schichten können optional weitere Elektroneninjektionsmaterialien aufgebracht werden, z. B. durch Aufdampfen oder auch aus Lösung durch Methoden, wie diese für die emittierenden Verbindungen beschrieben wurden. Als Elektroneninjektionsmaterialien können beispielsweise niedermolekulare Verbindungen, wie Triarylboranverbindungen oder auch Aluminiumtrishydroxychinolinat (Alq₃), aber auch entsprechende Polymere, wie beispielsweise Poly-pyridinderivate und ähnliche, verwendet werden. Es ist auch möglich, dünne Schichten der emittierenden Verbindung durch entsprechendes Dotieren in Elektroneninjektionsschichten umzuwandeln.
- Daran anschließend wird eine Kathode aufgedampft. Dies erfolgt i. d. R. durch einen Vakuumprozess und kann beispielsweise sowohl durch thermisches Bedampfen als auch durch Plasmaspritzen (Sputtern) geschehen. Die Kathode kann dabei vollflächig oder auch durch eine Maske strukturiert aufgebracht werden. Als Kathode werden i. d. R. Metalle mit geringer Austrittsarbeit, z. B. Alkali-, Erdalkali- und f-Übergangsmetalle, wie z. B. Li, Ca, Mg, Sr, Ba, Yb, Sm oder Aluminium oder auch Legierungen von Metallen oder mehrlagige Strukturen mit verschiedenen Metallen verwendet. Bei letzterem können auch Metalle mitverwendet werden, die eine relativ hohe Austrittsarbeit aufweisen, wie z. B. Ag. Es kann auch bevorzugt sein, zwischen das Metall und das emittierende Polymer bzw. die Elektroneninjektionsschicht, eine sehr dünne dielektrische Schicht (z. B. LiF, BaF₂ oder ähnliches) einzubringen. Die Kathoden sind i. d. R. zwischen 10 und 10000 nm, bevorzugt zwischen 20 und 1000 nm, dick.
- Anschließend werden die so erzeugten PLEDs bzw. Displays entsprechend angeschlossen und verkapselt, um dann getestet oder verwendet zu werden.

Die mit erfindungsgemäßem Verfahren synthetisierten Polymere eignen sich in hervorragender Weise zur Verwendung als Elektrolumineszenzmaterialien, da sie besser löslich sind als analoge Polymere, die mit herkömmlichen Verfahren synthetisiert wurden. Dadurch sind sie beispielsweise bei der Verarbeitung leichter filtrierbar und bilden homogenere Polymerfilme. Außerdem macht dieses Verfahren die Synthese neuer Polymere bzw. neuer Monomerkombinationen möglich, die nach herkömmlichem Verfahren zu unlöslichen Gelen führen. Auch die Verarbeitung der so erhaltenen Polymere durch verschiedene Drucktechniken ist deutlich verbessert gegenüber herkömmlich synthetisierten Polymeren.
Ebenso wie Polymere, die nach herkömmlichen Verfahren synthetisiert wurden, weisen die nach dem erfindungsgemäßen Verfahren erhaltenen Polymere vergleichbar hohe Effizienzen und Lebensdauern beim Betrieb in PLEDs auf. Dies ist zwar kein direkter Vorteil gegenüber den bekannten Polymeren, jedoch ist es für eine Anwendung essentiell, dass diese Eigenschaften auch bei dem erfindungsgemäßen Verfahren erhalten bleiben.

Als Elektrolumineszenzmaterialien im Sinne der Erfindung gelten Materialien, die als aktive Schicht in einer Elektrolumineszenzvorrichtung Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).
Der allgemeine Aufbau solcher Elektrolumineszenzvorrichtungen ist beispielsweise in US 4,539,507 und US 5,151,629 beschrieben. Polymere enthaltende Elektrolumineszenzvorrichtungen sind beispielsweise in WO 90/13148 oder EP 0 443 861 beschrieben.

Gegenstand der Erfindung ist ebenfalls die Verwendung von Polymeren, die durch erfindungsgemäßes Verfahren erhalten wurden in einer elektronischen Vorrichtung, insbesondere als Elektrolumineszenzmaterial in Elektrolumineszenzvorrichtungen. Jedoch ist es für den Fachmann ohne weiteres erfinderisches Zutun möglich, diese Polymere auch für andere Anwendungen zu benutzen, z. B. in organischen integrierten Schaltungen (O-ICs), in organischen Feld-Effekt-Transistoren (OFETs), in organischen Dünnfilmtransistoren (OTFTs), in organischen Solarzellen (O-SCs), in nicht-linearer Optik oder auch in organischen Laserdioden (O-Laser), um nur einige mögliche Anwendungen zu nennen.

Gegenstand der Erfindung sind daher weiterhin elektronische Vorrichtungen, z. B. organische integrierte Schaltungen (O-ICs), organische Feld-Effekt-Transistoren (OFETs), organische Dünnfilmtransistoren (OTFTs), organische Solarzellen (O-SCs), organische photorefraktive Elemente, nicht-lineare Optik oder organische Laserdioden (O-Laser), insbesondere jedoch polymere Leuchtdioden (PLEDs), enthaltend mindestens ein erfindungsgemäßes Polymer.

Die Erfindung wird durch die nachfolgenden Beispiele näher erläutert, ohne sie dadurch einschränken zu wollen.

### Beispiele

### Synthese erfindungsgemäßer Zusätze (EZ) gemäß Formel (I)

Die Identität der Verbindungen wurde durch ¹H NMR-Spektroskopie bewiesen, die Reinheit wurde durch HPLC-Messungen überprüft.

### Beispiel 1: Synthese von EZ1

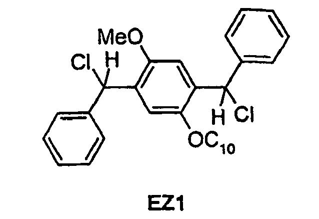

Dabei steht C₁₀ für eine 3,7-Dimethyloctyl-Gruppe. Die Synthese von 2,5-Bis(chlormethyl)-1-(3,7-dimethyloctyloxy)-4-methoxybenzol erfolgte gemäß der Literatur (H. Becker *et al., Macromolecules* **1999**, 32, 4925-4932)**.**

### Synthese von 2,5-Bis(acetoxymethyl)-1-(3,7-dimethyloctyloxyl-4-methoxybenzol

In einem 4L-Vierhalskolben mit Kühler, Innenthermometer und Magnetrührer wurden unter Stickstoff 324,6 g (0,95 mol) 2,5-Bis(chlormethyl)-1-(3,7-dimethyloctyloxy)-4-methoxybenzol vorgelegt und mit 233,3 g (2,85 mol) Natriumacetat, 145,5 g (1,43 mol) Essigsäureanhydrid und 2000 mL Eisessig versetzt. Die weiße Suspension wurde auf 90 °C erhitzt. Zunächst bildete sich eine klare Lösung, dann ein weißer Niederschlag. Nach 2 h bei 90 °C wurden am Rotationsverdampfer 1500 mL Essigsäure entfernt. Der Rückstand wurde mit 1500 mL Wasser versetzt. Das dabei anfallende wachsartige Produkt wurde durch Zugabe von 1000 mL Hexan gelöst. Die Phasen wurden getrennt, und die wässrige Phase wurde mit 2 x 300 mL Hexan extrahiert. Die vereinigten organischen Phasen wurden mit 1 x 500 mL Wasser gewaschen, über Na₂SO₄ getrocknet, und das Lösungsmittel wurde im Vakuum entfernt. Man erhielt 370 g (96 % d. Th.) eines gelben Öls, welches im Kühlschrank wachsartig fest wurde. Das Rohprodukt wurde ohne weitere Aufreinigung oder Charakterisierung direkt für die nächste Stufe eingesetzt.

### Synthese von 2,5-Bis(hydroxymethyl)-1-(3,7-dimethyloctyloxy)-4-methoxybenzol

In einem 3L-Vierhalskolben mit Kühler und KPG-Rührer wurden 144,9 g (3,62 mol) Natriumhydroxid in 1800 mL Ethanol gelöst. Nach Zugabe von 370 g (0,91 mol) 2,5-Bis(acetoxymethyl)-1-(3,7-dimethyloctyloxy)-4-methoxybenzol wurde die Mischung 3 h bei Raumtemperatur und 2,5 h bei 45 °C gerührt. Die Mischung wurde auf 2000 mL Wasser gegossen, und der entstehende Feststoff wurde filtriert, 3 x mit Wasser ausgerührt und wieder filtriert. Aus der Mutterlauge wurde nochmals eine zweite Fraktion gewonnen, die ebenfalls 3 x mit Wasser ausgerührt wurde. Die beiden vereinigten Fraktionen wurden 0,5 h bei Raumtemperatur mit Hexan ausgerührt, filtriert und getrocknet. Es wurden 183,8 g weißes Pulver erhalten, das ohne weitere Aufarbeitung und ohne weitere Charakterisierung direkt in der nächsten Stufe eingesetzt wurde.

### Synthese von 2-(3,7-Dimethyloctyloxy)-5-methoxyterephthalaldehyd

In einem 4L-Vierhalskolben mit Kühler, KPG-Rührer, Innenthermometer und Tropftrichter wurden 176,8 g (1,39 mol) Oxalylchlorid und 450 mL Dichlormethan vorgelegt und auf-50 °C abgekühlt. Dazu wurde innerhalb von 45 min. eine Lösung von 253,5 g (3,43 mol) DMSO in 450 mL Dichlormethan getropft. Die Mischung wurde 30 min. nachgerührt. Dann wurde über 2,5 h eine Lösung aus 183,8 g (0,57 mol) 2,5-Bis(hydroxymethyl)-1-(3,7-dimethyloctyloxy)-4-methoxybenzol in 500 mL Dichlormethan zugetropft. Nach Zugabe von 100 mL bildete sich ein weißer Niederschlag. Nach Zugabe von 400 mL der Lösung wurden weitere 500 mL Dichlormethan zugegeben. Nach der vollständigen Zugabe wurde 15 min. nachgerührt, dann wurden innerhalb von 1 h 151,8 g (1,5 mol) Triethylamin zugetropft. Über Nacht ließ man auf Raumtemperatur kommen, dann wurden 1500 mL Wasser zugegeben und 0,5 h gerührt. Die Phasen wurden getrennt, und die wässrige Phase wurde mit 2 x 300 mL Wasser extrahiert. Die vereinigten organischen Phasen wurden mit 1 x 500 mL Wasser gewaschen, über Na₂SO₄ getrocknet, und das Lösungsmittel wurde im Vakuum entfernt. Man erhielt 175,6 g (58 % d. Th.) des Produktes, das ohne weitere Aufreinigung und ohne weitere Charakterisierung für die nächste Stufe eingesetzt wurde.

### 2,5-Bis(phenylhydroxymethyl)-1-(3,7-dimethyloctyloxy)-4-methoxybenzol

In einem 6L-Vierhalskolben mit KPG-Rührer, Rückflusskühler und 2 Tropftrichtern wurden 26,7 g (1,1 mol) Magnesiumspäne vorgelegt. Die Apparatur wurde unter Argon ausgeheizt. Bei Raumtemperatur wurden 10 mL absolutes THF und einige Kristalle Iod zugegeben und kurz gerührt. Anschließend wurden in die nicht gerührte Lösung einige mL Brombenzol getropft und an der Eintropfstelle kurz mit dem Heißluftgebläse erhitzt. Nach Start der Reaktion wurden insgesamt (inklusive der bereits zugegebenen Menge) 215 g (1,37 mol) Brombenzol innerhalb von 45 min. zugetropft. Gleichzeitig wurden 490 mL absolutes THF zugegeben. Nach dem Zutropfen wurde der Ansatz 1,5 h unter Rückfluss gerührt. Anschließend wurde unter Eiskühlung eine Lösung von 175,6 g (0,55 mol) 2-(3,7-Dimethyloctyloxy)-5-methoxyterephthalaldehyd in 600 mL absolutem THF zugetropft. Nach der Hälfte der Zugabe wurde das entstandene Gel mit 3000 mL destilliertem Toluol versetzt und unter Erwärmung auf 70 °C gelöst. Nach Abkühlen auf Raumtemperatur wurde die restliche Lösung des Terephthalaldehyds zugetropft, und die viskose Lösung wurde 4 h bei 70 °C nachgerührt. Die Reaktionsmischung wurde in 4000 mL Eiswasser mit 40 mL konz. H₂SO₄ eingerührt. Die Phasen wurden getrennt und die wässrige Phase mit 1 x 500 mL Ethylacetat extrahiert. Die vereinigten organischen Phasen wurden mit 1 x 300 mL Wasser gewaschen, über Na₂SO₄ getrocknet, und das Lösungsmittel wurde im Vakuum entfernt. Das Rohprodukt wurde mit n-Hexan zweimal bei Raumtemperatur und einmal bei 50 °C ausgerührt und filtriert. Weitere Reinigung erfolgte durch Aufschmelzen des Rohprodukts bei 65 °C in Hexan. Dieser Vorgang wurde noch drei weitere Male wiederholt. Man erhielt 157,1 g (60 % d. Th.) des Produkts in 95 %iger Reinheit, das direkt für die weitere Synthese eingesetzt wurde. NMR (CDCl₃): 7,38-7,44 (m, 4H), 7,24-7,35 (m, 6H), 7,09-9,12 (m, 1 H), 7,04-7,07 (m, 1 H), 6,54-6,57 (m, 2H, C(OH)H), 3,85-3,95 (m, 2H, OCH₂), 3,76+3,77 (2 x s, 3H, OCH₃), 0,83-1,69 (m, 19H).

### Synthese von 2,5-Bis(phenylchlormethyl)-1-(3,7-dimethyloctyloxy)-4-methoxybenzol

In einem 2L-Vierhalskolben mit KPG-Rührer, Kühler, Tropftrichter, Thermometer und zwei Waschflaschen (eine leer, eine mit 15 %iger Natronlauge) wurden 156 g (0,327 mol) 2,5-Bis(phenylhydroxymethyl)-1-(3,7-dimethyloctyloxy)-4-methoxybenzol in 600 mL Hexan aufgeschlämmt und mit 1 mL Pyridin versetzt. Dazu wurden bei Raumtemperatur langsam 155,7 g (1,31 mol) Thionylchlorid zugetropft. Der Ansatz wurde 15 h bei Raumtemperatur und 2,5 h unter Rückfluss gerührt. Zur Aufarbeitung wurde die Reaktionsmischung bei Raumtemperatur unter Rühren mit 400 mL gesättigter NaHCO₃-Lösung versetzt und über Nacht gerührt. Die Phasen wurden getrennt und die wässrige Phase mit 1 x 200 mL Hexan extrahiert. Die vereinigten organischen Phasen wurden mit 1 x 200 mL Wasser gewaschen und über Na₂SO₄ getrocknet. Das Lösungsmittel wurde im Vakuum entfernt, und das Rohprodukt wurde durch zweimalige Kurzwegdestillation gereinigt (1. 140-195 °C, Kühlung 40°C, < 10⁻³ mbar, 2. 185 °C, Kühlung 40 °C, < 10⁻³ mbar). Es wurden 121 g (72 % d. Th.) erhalten. NMR (CDCl₃): 7,34-7,40 (m, 4H), 7,20-7,34 (m, 6H), 6,88 (s, 1 H), 6,84 (s, 1 H), 5,98-6,02 (m, 2H, CHCl), 3,79-3,92 (m, 2H, OCH₂), 3,71 (s, 3H, OCH₃), 0.80-1,72 (m, 19H).

### Beispiel 2: Synthese von EZ2

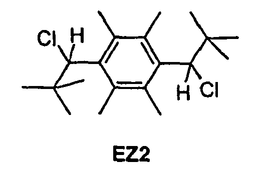

Die Synthese von 1,4-Diformyl-2,3,5,6-tetramethylbenzol (A. P. Yakubov *et al., Tetrahedron* **1993**, *49*, 3397) und von 1,4-Bis(1-hydroxy-2,2-dimethylpropyl)-2,3,5,6-tetramethylbenzol (D. Casarini *et al., J*. *Org. Chem.* **1996,** *61*, 6240) erfolgte gemäß der Literatur.

### Synthese von 1,4-Bis(1-chloro-2,2-dimethylpropyl)2,3,5,6-tetramethylbenzol

In einem 1L-Vierhalskolben mit mechanischem Rührer, Rückflusskühler, Tropftrichter, Thermometer und zwei Waschflaschen (eine leer, eine mit 15%iger Natronlauge) wurden 61,31 g (0,2 mol) 1,4-Bis(1-hydroxy-2,2-dimethylpropyl)-2,3,5,6-tetramethylbenzol in 32 g (0,41 mol, 33 mL) Pyridin und 100 mL Hexan suspendiert. Dazu wurden unter Rühren 48,4 g (0,41 mol, 30 mL) Thionylchlorid langsam zugetropft, so dass die Innentemperatur 50 °C nicht überstieg. Dann wurde 5 h unter Rückfluss erhitzt. Die Reaktionslösung wurde nach dem Abkühlen vorsichtig unter Rühren mit 200 mL Eiswasser versetzt. Dann wurden 400 mL Ethylacetat zugegeben, und die Phasen wurden getrennt. Die wässrige Phase wurde mit 2 x 100 mL Ethylacetat extrahiert. Die vereinigten organischen Phasen wurden mit 100 mL NaHCO₃-Lösung und mit 3 x 100 mL Wasser gewaschen und über MgSO₄ getrocknet. Das Produkt wurde durch wiederholte Umkristallisation aus Ethylacetat/Hexan gereinigt. Ausbeute: 20,98 g (61 % d. Th.).
¹H NMR (CDCl₃): 0.98 (s, 18 H, *tert*-Butyl-Gruppen), 2,35 (s, 12 H, Me), 4,73 (s, 2 H, CHCl).

### Beispiel 3: Synthese von EZ3

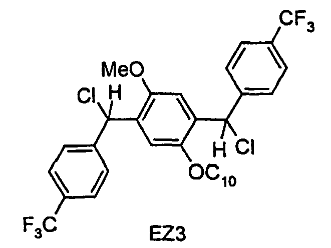

Die Synthese von 2,5-Bis(p-trifluormethyl-phenylchlormethyl)-1-(3,7-dimethyloctyloxy)-4-methoxybenzol erfolgte in Analogie zur Synthese von **EZ1**. Die Aufreinigung erfolgte durch zweimalige Kurzwegdestillation (1. 150-215 °C, Kühlung 40 °C, < 10⁻³ mbar, 2. 191 °C, Kühlung 40 °C, < 10⁻³ mbar). ¹H-NMR (CDCl₃): 7,78-7,85 (m, 4H), 7,49-7,60 (m, 4H), 6,95 (s, 1 H), 6,92 (s, 1 H), 6,02-6,06 (m, 2H, CHCl), 3,86-3,99 (m, 2H, OCH₂), 3,79 (s, 3H, OCH₃), 0.80-1,75 (m, 19H). ¹⁹F-NMR (CDCl₃): -66,8 ppm (gegen CCl₃F als internen Standard).
Diese Verbindung wurde synthetisiert, um ¹⁹F-NMR-spektroskopisch den Einbau in das Polymer zu untersuchen.

### Beispiel 4: Synthese typischer Monomere

Die Synthese möglicher Monomere für die Polymerisation gemäß GILCH wurde bereits in den Anmeldeschriften WO 01/34722 (EP 1232225) und WO 99/24526 gezeigt. Die Synthese möglicher Monomere für die Polymerisation gemäß der Sulfinyl-Precursor-Route wurde veröffentlicht von A. J. van Bremen *et al. (J. Org. Chem.* **1999,** *64*, 3106). An dieser Stelle sei deshalb nur auf diese Schriften verwiesen.

Die im Folgenden beispielhaft verwendeten Monomere seien hier nochmals der Übersichtlichkeit halber aufgeführt:

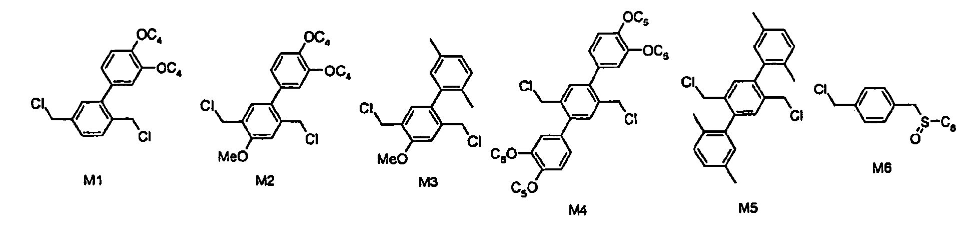

Dabei steht C₄ für eine 2-Methylpropylgruppe, C₅ für eine 2-Methylbutylgruppe und C₈ für eine *ⁿ*Octylgruppe.

### Polymer-Synthese

Im Folgenden bezieht sich die prozentuale molare Menge des erfindungsgemäßen Zusatzes (EZ1, EZ2 und EZ3) jeweils auf die molare Gesamtmenge an eingesetztem Monomer.

### Beispiel 5: Synthese von Polymer P1

Copolymer aus 50 % **M4, 40** % **M1** und 10 % **M5** unter Zusatz von 10 mol% **EZ1:**

In einem trockenen 1L-Vierhalskolben mit mechanischem Teflonrührer, Rückflusskühler, Thermometer und Tropftrichter wurden 570 mL trockenes und sauerstofffreies 1,4-Dioxan auf 99 °C erhitzt. Dann wurde eine Lösung von 2,687 g (4 mmol) **M4**, 1,265 g (3,2 mmol) **M1**, 0,307 g (0,8 mmol) **M5** und 0,411 g (0,8 mmol) **EZ1** in 30 mL trockenem 1,4-Dioxan zugesetzt. Nun wurde eine Lösung von 2,36 g (21 mmol) Kalium-*tert*-butanolat in 21 mL trockenem 1,4-Dioxan innerhalb von 5 Minuten zu der intensiv gerührten Mischung zugetropft. Die Farbe änderte sich dabei von farblos über grün nach gelbgrün. Nach 5 Minuten wurden weitere 1,79 g (16 mmol) Kalium-*tert*-butanolat in 16 mL trockenem 1,4-Dioxan zugegeben. Nach 2 h Rühren bei 98 bis 100 °C wurde auf 55 °C abgekühlt und ein Gemisch aus 4 mL Essigsäure und 4 mL 1,4-Dioxan zugesetzt. Die nun gelbe Lösung wurde auf 850 mL intensiv gerührtes Wasser gegossen. Das ausgefallene Polymer wurde durch Filtration durch einen Polypropylenfilter isoliert, mit Methanol gewaschen und im Vakuum getrocknet. Das Rohpolymer wurde bei 60 °C in 250 mL THF gelöst und durch Zusatz von 250 mL Methanol bei 40 °C gefällt. Nach Trocknen unter Vakuum wurde dieser Schritt ein weiteres Mal durchgeführt. Man erhielt nach Trocknen im Vakuum 1,65 g (41 % d. Th.) des Polymers P1 als hellgelbe Fasern.
GPC (Polystyrol-Standard, UV-Detektion 254 nm): M_{w} = 351 k, Mₙ = 73k.

Ein Vergleichspolymer V1, das unter ansonsten gleichen Bedingungen, jedoch ohne Zusatz von EZ1 synthetisiert wurde, bildete ein unlösliches Gel.

### Beispiel 6: Synthese von Polymer P2 (3)

Copolymer aus 50 % **M1**, 35 % **M2** und 15 % **M3** unter Zusatz von 10 mol% **EZ2**:

In einem trockenen 3L-Vierhalskolben mit mechanischem Teflonrührer, Rückflusskühler, Thermometer und Tropftrichter wurden 1700 mL trockenes und sauerstofffreies 1,4-Dioxan auf 99 °C erhitzt. Dann wurde eine Lösung von 5,63 g (14,25 mmol) **M1,** 4,24 g (9,98 mmol) **M2, 1,32** g (4,28 mmol) **M3** und 0,98 g (2,85 mmol) **EZ2** in 25 mL trockenem 1,4-Dioxan zugesetzt. Nun wurde eine Lösung von 8,30 g (74 mmol) Kalium-*tert*-butanolat in 74 mL trockenem 1,4-Dioxan innerhalb von 5 Minuten zu der intensiv gerührten Mischung zugetropft. Die Farbe änderte sich dabei von farblos über gelb nach gelborange. Nach 5 Minuten wurden weitere 7,7 g (68,5 mmol) Kalium-*tert*-butanolat in 70 mL trockenem 1,4-Dioxan zugegeben. Nach 2 h Rühren bei 98 bis 100 °C wurde auf 50 °C abgekühlt und ein Gemisch aus 17 mL Essigsäure und 18 mL 1,4-Dioxan zugesetzt. Die nun orangefarbene Lösung wurde auf 1900 mL intensiv gerührtes Wasser gegossen. Das ausgefallene Polymer wurde durch Filtration durch einen Polypropylenfilter isoliert, mit Methanol gewaschen und im Vakuum getrocknet. Das Rohpolymer wurde bei 60 °C in 750 mL THF gelöst und durch Zusatz von 750 mL Methanol bei 40 °C gefällt. Nach Waschen mit Methanol und Trocknen unter Vakuum wurde dieser Schritt ein weiteres Mal mit 500 mL THF und 500 mL Methanol durchgeführt. Man erhielt nach Trocknen im Vakuum 3,40 g (43 % d. Th.) des Polymers P2 (3) als gelborange Fasern.
GPC (Polystyrol-Standard, UV-Detektion 254 nm): M_{w} = 579k, Mₙ = 145k.

Ein Vergleichspolymer **V2**, das unter ansonsten identischen Bedingungen ohne erfindungsgemäßen Zusatz **EZ2** synthetisiert wurde, hatte ein M_{w} = 1120k und ein Mₙ = 342k.

### Beispiel 7: Synthese von Polymer P3

Homopolymer aus 100 % **M6** unter Zusatz von 10 mol% **EZ1**:

In einem trockenen 500mL-Vierhalskolben mit mechanischem Teflonrührer, Thermometer und Tropftrichter wurde eine Lösung von 6,0 g (20 mmol) **M6** und 1,03 g (2 mmol) **EZ1** in 140 mL trockenem THF 1 h bei 30 °C entgast, indem ein Stickstoffstrom durch die Lösung geleitet wurde. Dazu wurde eine entgaste Lösung von 2,36 g (21 mmol) Kalium-*tert-*butanolat in 60 mL trockenem und sauerstofffreiem THF in einer Portion zugegeben, und die Mischung wurde 1 h bei 30 °C gerührt. Dann wurde die Reaktionsmischung auf 1000 mL stark gerührtes Eiswasser gegeben und das ausgefallene Polymer durch Filtration durch einen Polypropylenfilter isoliert, mit Methanol gewaschen und im Vakuum getrocknet. Das Rohpolymer wurde bei 60 °C in 500 mL THF gelöst, durch Zugabe in 750 mL Methanol gefällt, filtriert und getrocknet. Dieser Schritt wurde noch ein weiteres Mal wiederholt. Man erhielt nach dem Trocknem im Vakuum 3,61 g (58 % d. Th.) des Polymers **P3** als farblose Fasern.
GPC (Polystyrol-Standard, UV-Detektion 254 nm): M_{w} = 483k, Mₙ = 173k.

Ein Vergleichspolymer **V3,** das unter ansonsten identischen Bedingungen, jedoch ohne erfindungsgemäßen Zusatz **EZ3**, synthetisiert wurde, hatte ein M_{w} = 812k und ein Mₙ = 253k.

Die thermische Umwandlung dieser an der Aryleinheit unsubstituierten Polymere zu Poly(arylenvinylenen) führt zu unlöslichen Polymeren. Deshalb wurde diese Umwandlung hier nicht in Lösung durchgeführt.

### Beispiel 8: Synthese von Polymer P4

Copolymer aus 50 % **M4**, 40 % **M1** und 10 % **M5** unter Zusatz von 10 mol% **EZ3**:

Die Synthese von **P4** wurde in Analogie zu **P1** durchgeführt. Jedoch wurde hier der Zusatz **EZ3** (0,518 g, 0,8 mmol) verwendet, um dessen Einbau in das Polymer ¹⁹F-NMR-spektroskopisch zu untersuchen. Es wurden hiervon keine Elektrolumineszenzuntersuchungen durchgeführt. Für dieses Polymer wurde durch GPC mit internem Polystyrolstandard ein Molekulargewicht von M_{w} = 382k und Mₙ= 84k bestimmt.
Zur ¹⁹F-NMR-spektroskopischen Untersuchung wurden 5 mg des Polymers **P4** unter Zusatz von 1,5·10⁻³ mg (1,03·10⁻⁵ mol) Trifluortoluol als quantitative Referenz in 0,8 mL CDCl₃ gelöst, und das ¹⁹F-NMR-Spektrum wurde aufgenommen. Das Signal von Trifluortoluol wurde auf-63,9 ppm geeicht. Das ¹⁹F-Signal des Polymers wurde bei -64,5 bis -66 ppm als verbreitertes Signal detektiert. Durch Intergration über das Fluorsignal des Polymers und der Referenzsubstanz wurde ein Fluorgehalt des Polymers von ca. 34 ppm bestimmt. Daraus lässt sich bestimmen, dass der Zusatz EZ3 auch in die Polymerkette eingebaut wird und nicht nur die Endgruppen des Polymers darstellt. Würde EZ3 nur die Endgruppen darstellen, würde man einen Fluorgehalt von ca. 11 ppm erwarten.

Ebenso wie für Polymer **P1, P2 (3), P3** und **P4** beschrieben, wurden weitere Polymere mit dem erfindungsgemäßem Verfahren und Vergleichspolymere mit herkömmlichen Verfahren synthetisiert. Die Polymere sind in Tabelle 1 zusammengefasst zusammen mit den Ergebnissen der GPC-Bestimmung des Molekulargewichts, Angaben zur Viskosität und Charakterisierung der Elektrolumineszenz (soweit möglich).

**Tabelle 1**

| Polymer | M1^{[a]} | M2^{[a]} | M3^{[a]} | M4^{[a]} | M5^{[a]} | M6^{[a]} | EZ1^{[b]} | EZ2^{[b]} | Kommentar | Mₙ^{[c]} | M_{w}^{[c]} | Viskosität^{[d]} | Max. Eff.^{[e]} | LD^{[l]} | λₘₐₓ^{[g]} |
|---|---|---|---|---|---|---|---|---|---|---|---|---|---|---|---|
| P1 | 40 | | | 50 | 10 | | 10 | | | 73k | 351 k | 2,2 | 13,8 | 460 | 518 |
| V1 | 40 | | | 50 | 10 | | | | vergelt | | | | | | |
| P2 (1a) | 50 | 35 | 15 | | | | | 2,5 | | 214k | 974k | 10,2 | 11,1 | 1050 | 545 |
| P2 (1b) | 50 | 35 | 15 | | | | | 2,5 | | 210k | 968k | 10,1 | 11,2 | 1070 | 544 |
| P2 (1c) | 50 | 35 | 15 | | | | | 2,5 | | 209k | 961k | 10,0 | 11,3 | 985 | 545 |
| P2 (2) | 50 | 35 | 15 | | | | | 5 | | 159k | 778k | 5,7 | 11,1 | 1100 | 544 |
| P2 (3) | 50 | 35 | 15 | | | | | 10 | | 145k | 579k | 2,7 | 10,9 | 785 | 545 |
| P2 (4) | 50 | 35 | 15 | | | | | 15 | | 122k | 428k | 1,7 | 10,8 | 820 | 546 |
| V2 | 50 | 35 | 15 | | | | | | | 342k | 1120k | 22 | 11,5 | 1000 | 544 |
| P3 | | | | | | 100 | 10 | | | 173k^{[h]} | 483k^{[h]} | n. a. | n. a. | n. a. | |
| V3 | | | | | | 100 | | | | 253k^{[h]} | 812k^{[h]} | n. a. | n. a. | n. a. | |
| P4 (1) | 25 | 60 | 15 | | | | 5 | | | 200k | 887k | 6,9 | 10,5 | 2200 | 551 |
| P4(2) | 25 | 60 | 15 | | | | 10 | | | 95k | 563k | 3,0 | 10,2 | 2000 | 553 |
| V4 | 25 | 60 | 15 | | | | | | vergelt | | | | | | |
| P5 (1) | 40 | | | 30 | 30 | | 5 | | | 201k | 822k | 9,1 | 15,6 | 621 | 513 |
| P5(2) | 40 | | | 30 | 30 | | 10 | | | 156k | 586k | 4,6 | 13,8 | 523 | 513 |
| V5 | 40 | | | 30 | 30 | | | | vergelt | | | n. a. | n. a. | n. a. | |

| | | | | | | | | | | | | | | | |
|---|---|---|---|---|---|---|---|---|---|---|---|---|---|---|---|
| [a] Angaben in Prozent bezogen auf die Gesamtzusammensetzung des Polymers ohne Einbezug des erfindungsgemäßen Zusatzes. [b] Menge des erfindungsgemäßen Zusatzes in Prozent bezogen auf die Gesamtmenge an Monomer. [c] in g/mol; bestimmt durch GPC (THF; Säulensatz SDV500, SDV1000, SDV10000 (Fa. PSS) 35 °C, UV-Detektion 254 nm, Polystyrol-Standard). [d] in mPas; 0,5 %ige Lösung in Toluol, 40 s⁻¹. [e] maximale Effizienz in cd/A, zur Herstellung der PLEDs s. Beispiel 9. [f] Lebensdauer bis Abfall der Anfangshelligkeit auf 80 %; Messung bei Raumtemperatur und einer Anfangshelligkeit von 1000 cd/m²; Messbeginn 1 h nach Beginn des Stromflusses; zur Herstellung der PLEDs Beispiel 9. [g] Maximum der Emission (Elektrolumineszenz) in nm. [h] Molekulargewicht bezogen auf das Precursor-Polymer. | | | | | | | | | | | | | | | |

Aus dem Vergleich der Beispielpolymere P mit den Vergleichspolymeren V ist leicht erkennbar, dass das Molekulargewicht und damit die Löslichkeit der Polymere und Viskosität der Polymerlösungen sehr stark durch das gewählte Verfahren beeinflusst wird. Gerade Polymere, die nach Verfahren gemäß Stand der Technik synthetisiert wurden, weisen häufig ein für viele Anwendungen zu hohes Molekulargewicht auf oder erweisen sich als nicht verarbeitbar bzw. unlöslich im Sinne diesen Textes.

Die Einträge in Tabelle 1 belegen, dass das erfindungsgemäße Verfahren exzellent zur Molekulargewichtskontrolle bei der Synthese von Poly(arylenvinylenen) geeignet ist. Dabei werden die Eigenschaften der Polymere beim Einsatz in PLEDs (Effizienz, Lebensdauer) nicht beeinflusst. Weiterhin verbessert das erfindungsgemäße Verfahren die Reproduzierbarkeit deutlich, wie sich an den Ergebnissen für Polymer P2 (1a) - (1c) leicht ablesen lässt.

### Beispiel 9: Herstellung und Charakterisierung von LEDs

Die Herstellung von LEDs erfolgte nach dem im Folgenden skizzierten allgemeinen Verfahren. Dieses wurde im Einzelfall auf die jeweiligen Gegebenheiten (z. B. Lösungsviskosität und optimale Schichtdicke der Verbindung im Device) angepasst. Die im Nachfolgenden beschriebenen LEDs waren jeweils Zweischichtsysteme, d. h. Substrat//ITO//PEDOT//Polymer//Kathode. PEDOT ist ein Polythiophen-Derivat. Allgemeines Verfahren zur Herstellung hocheffizienter, langlebiger LEDs: Nach dem Zuschneiden der ITO-beschichteten Substrate (z. B. Glasträger, PET-Folie) auf die richtige Größe werden sie in mehreren Reinigungsschritten im Ultraschallbad gereinigt (z. B. Seifenlösung, Millipore-Wasser, Isopropanol). Zur Trocknung werden sie mit einer N₂-Pistole abgepustet und in einem Exsikkator gelagert. Vor der Beschichtung mit dem Poly(arylenvinylen) werden sie mit einem Ozon-Plasma-Gerät für ca. 20 Minuten behandelt. Von dem jeweiligen Poly(arylenvinylen) wird eine Lösung (in der Regel mit einer Konzentration von 4-25 mg/mL in beispielsweise Toluol, Chlorbenzol, Xylol:Cyclohexanon (4:1)) angesetzt und durch Rühren bei Raumtemperatur gelöst. Je nach Verbindung kann es auch vorteilhaft sein, für einige Zeit bei 50 - 70 °C zu rühren. Hat sich die Verbindung vollständig gelöst, wird sie durch einen 5 µm Filter filtriert und bei variablen Geschwindigkeiten (400-6000) mit einem Spin-coater aufgeschleudert. Die Schichtdicken können dadurch im Bereich von ca. 50 und 300 nm variiert werden. Vorab wird meist auf das (strukturierte) ITO ein leitfähiges Polymer, bevorzugt dotiertes PEDOT oder PANI, aufgebracht. Auf die so erhaltenen Filme werden noch Elektroden aufgebracht. Dies geschieht in der Regel durch thermisches Verdampfen (Balzer BA360 bzw. Pfeiffer PL S 500). Anschließend wird die transparente ITO-Elektrode als Anode und die Metallelektrode (z. B. Ba, Yb, Ca) als Kathode kontaktiert und die Device-Parameter bestimmt.
Die Resultate, die mit Poly(arylenvinylenen), die durch erfindungsgemäßes Verfahren synthetisiert wurden, erhalten wurden, sind in Tabelle 1 zusammengefasst.

## Patentansprüche

1. Verfahren zur Herstellung von Poly(arylenvinylenen) aus Bis(halomethyl)arylenen oder Halomethyl-sulfinylmethyl-arylenen durch baseninduzierte Dehydrohalogenierung, **dadurch gekennzeichnet, dass** die Umsetzung in Gegenwart von 0,1 - 80 mol% einer oder mehrerer Verbindungen gemäß Formel (I) durchgeführt wird: 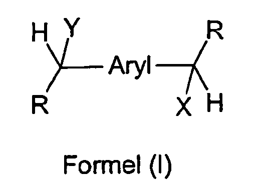 wobei die Symbole folgende Bedeutungen haben:
Aryl ist bei jedem Auftreten gleich oder verschieden ein bivalentes aromatisches oder heteroaromatisches Ringsystem mit 2 bis 40 C-Atomen, welches mit Resten R¹ substituiert oder auch unsubstituiert sein kann, oder eine mit R¹ substituierte oder unsubstituierte Stilbenyleneinheit; dabei sind die beiden Substituenten CHXR und CHYR so angeordnet, dass eine gerade Anzahl aromatischer Atome dazwischen liegt; die Aryl- und Heteroaryl-Systeme können dabei auch Teil eines größeren kondensierten aromatischen Ringsystems sein; die möglichen Substituenten R¹ können potenziell an jeder freien Position sitzen;
R ist bei jedem Auftreten gleich oder verschieden eine Alkylkette mit 1 bis 40 C-Atomen, die geradkettig, verzweigt oder cyclisch sein kann, die außerdem mit einem oder mehreren Resten R¹ substituiert oder unsubstituiert sein kann, in der auch ein oder mehrere nicht benachbarte C-Atome durch -CR²=CR²-, -C≡C-, -NR²-, -O-, -S-, -CO-, -CO-O-, -CONR²-, -O-CO-O- ersetzt sein können, wobei auch ein oder mehrere H-Atome durch Fluor ersetzt sein können, ein aromatisches oder heteroaromatisches Ringsystem mit 2 bis 40 C-Atomen, welches mit R¹ substituiert oder unsubstituiert sein kann, eine mit R¹ substituierte oder unsubstituierte Stilbenyl- bzw. Tolanyleinheit, -Si(R²)₃, -N(R²)₂, -OR² oder eine Kombination dieser Systeme; die Aryl- und Heteroaryl-Systeme können dabei auch Teil eines größeren kondensierten aromatischen Ringsystems sein; die möglichen Substituenten können potenziell an jeder freien Position sitzen;
X ist bei jedem Auftreten gleich oder verschieden Cl, Br, 1, Trifluormethansulfonat oder Arylsulfonat;
Y ist bei jedem Auftreten gleich oder verschieden Cl, Br, l, Trifluormethansulfonat, Arylsulfonat, -S(O)-R² oder R¹;
R¹ ist bei jedem Auftreten gleich oder verschieden eine geradkettige, verzweigte oder cyclische Alkylkette mit 1 bis 40 C-Atomen, in der auch ein oder mehrere nicht benachbarte C-Atome durch -CR²=CR²-, -C≡C-, -NR²-, -O-, -S-, -CO-, -CO-O-, -CONR²-, -O-CO-O- ersetzt sein können, wobei auch ein oder mehrere H-Atome durch Fluor ersetzt sein können, ein aromatisches oder heteroaromatisches Ringsystem mit 2 bis 40 C-Atomen, welches auch durch ein oder mehrere nicht-aromatische Reste R¹ substituiert sein kann, eine substituierte oder unsubstituierte Vinylgruppe oder Cl, F, CN, N(R²)₂, B(R²)₂; die Aryl- und Heteroaryl-Systeme können dabei auch Teil eines größeren kondensierten aromatischen Ringsystems sein; die möglichen Substituenten können potenziell an jeder freien Position sitzen; dabei können auch zwei oder mehrere Reste R¹ miteinander ein Ringsystem bilden;
R² ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch -O-, -S-, -CO-O-, -O-CO-O- ersetzt sein können, wobei auch ein oder mehrere H-Atome durch Fluor ersetzt sein können, ein Aryl- oder Heteroaryl-System mit 2 bis 40 C-Atomen, welches auch durch ein oder mehrere nicht-aromatische R¹ substituiert sein kann.

2. Verfahren gemäß Anspruch 1, **dadurch gekennzeichnet, dass** die Halogenatome in den Bis(halomethyl)arylen-Monomeren bzw. den Halomethyl-sulfinylmethylarylen-Monomeren gleich oder verschieden Cl, Br oder I sind.

3. Verfahren gemäß Anspruch 1 und/oder 2, **dadurch gekennzeichnet, dass** die Polymerisation in einem Ether, einem aromatischen Kohlenwasserstoff, einer chlorierten aromatischen Verbindung oder einer Mischung dieser Lösungsmittel durchgeführt wird, falls Bis(halomethyl)arylen-Monomere verwendet werden, oder dass die Polymerisation in einem Ether, einem aromatischen Kohlenwasserstoff, einer chlorierten aromatischen oder nicht-aromatischen Verbindung, DMSO, einem Alkohol oder einer Mischung dieser Lösungsmittel durchgeführt wird, falls Halomethyl-sulfinylmethyl-arylen-Monomere verwendet werden.

4. Verfahren gemäß einem oder mehreren der Ansprüche 1 bis 3, **dadurch gekennzeichnet, dass** die Reaktion in einem Konzentrationsbereich von 0,005 bis 5 mol/l (Monomer/Lösungsvolumen) durchgeführt wird.

5. Verfahren gemäß einem oder mehreren der Ansprüche 1 bis 4, **dadurch gekennzeichnet, dass** als Basen Alkalimetallhydroxide, Alkalimetallalkoholate oder organische Amine oder Amide verwendet werden oder auch Alkalimetallhydride oder Metallorganyle, sofern als Lösungsmittel nicht DMSO, keine Alkohole und keine chlorierten Lösemittel verwendet werden.

6. Verfahren gemäß einem oder mehreren der Ansprüche 1 bis 5, **dadurch gekennzeichnet, dass** die Menge der eingesetzten Base im Bereich von 2 bis 10 Äquivalenten (bezogen auf ein Äquivalent Monomer) liegt, falls als Monomere Bis(halomethyl)aryl-Verbindungen eingesetzt werden, und im Bereich von 1 bis 10 Äquivalenten (bezogen auf ein Äquivalent Monomer) liegt, falls als Monomere Halomethyl-sulfinylmethyl-aryl-Verbindungen eingesetzt werden.

7. Verfahren gemäß einem oder mehreren der Ansprüche 1 bis 6, **dadurch gekennzeichnet, dass** zwischen 2 und 40 mol% (bezogen auf die Gesamtmenge der restlichen Monomere) einer oder mehrerer Verbindungen gemäß Formel (I) zugesetzt werden.

8. Verfahren gemäß einem oder mehreren der Ansprüche 1 bis 7, **dadurch gekennzeichnet, dass** für die Verbindung gemäß Formel (I) folgendes gilt:
Aryl ist bei jedem Auftreten gleich oder verschieden ein bivalentes aromatisches Ringsystem mit 2 bis 40 C-Atomen, welches mit bis zu 4 Substituenten R¹ substituiert oder auch unsubstituiert sein kann, oder eine mit R¹ substituierte oder unsubstituierte Stilbenyleneinheit; dabei sind die beiden Substituenten CHXR und CHYR so angeordnet, dass eine gerade Anzahl aromatischer Atome dazwischen liegt; das Arylsystem kann dabei auch Teil eines größeren kondensierten aromatischen Ringsystems sein; die möglichen Substituenten R¹ können dabei potenziell an jeder freien Position sitzen;
R ist wie in Anspruch 1 definiert;
X ist bei jedem Auftreten gleich oder verschieden Cl, Br, I;
Y ist wie in Anspruch 1 definiert;
R¹, R² sind wie in Anspruch 1 definiert.

9. Verfahren gemäß Anspruch 8, **dadurch gekennzeichnet, dass** die Verbindung gemäß Formel (I) aus den Formeln (II) bis (XXV) ausgewählt ist, wobei diese substituiert oder unsubstituiert sein können:

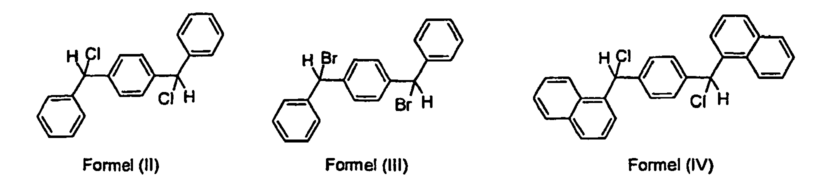

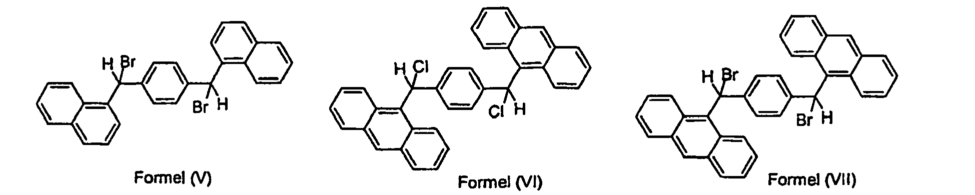

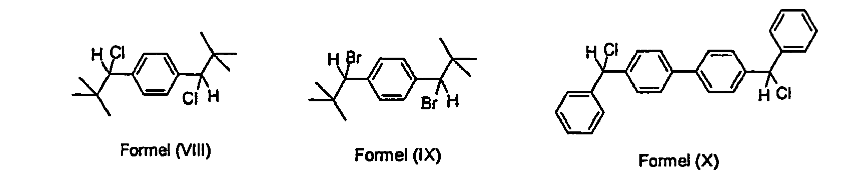

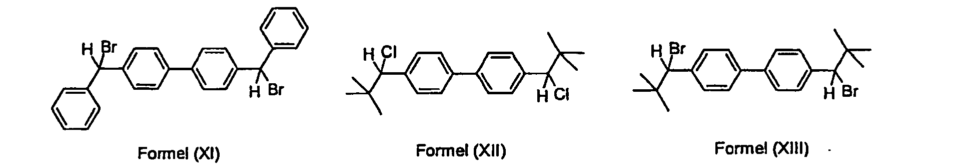

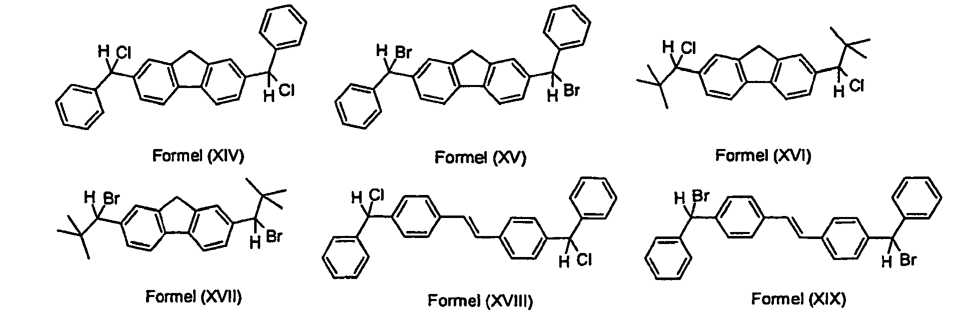

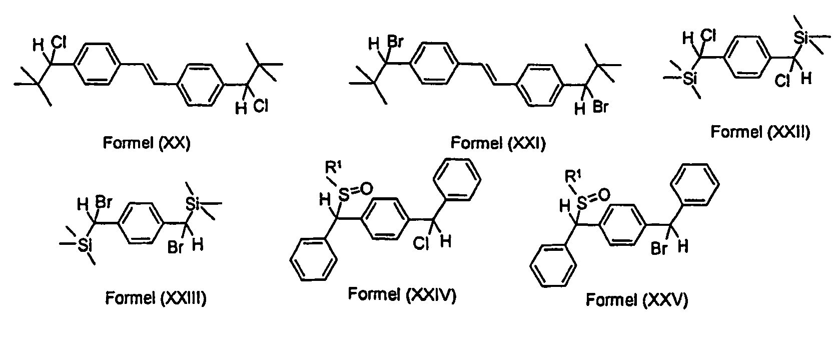

10. Verfahren gemäß einem oder mehreren der Ansprüche 1 bis 9, **dadurch gekennzeichnet, dass** das Poly(arylenethylen)-Precursor Polymer, das erhalten wird, wenn als Monomere Halomethyl-sulfinylmethyl-aryl-Verbindungen eingesetzt werden, durch thermische Behandlung in das konjugierte Poly(arylenvinylen) umgewandelt wird.

11. Poly(arylenvinylene) enthaltend mindestens 0,1 mol% Einheiten gemäß Formel (Ia) und/oder (Ib), 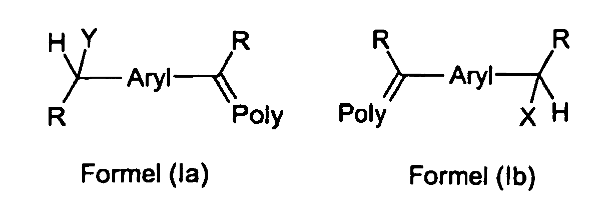 erhältlich aus Bis(halomethyl)arylenen oder Halomethyl-sulfinylmethyl-arylenen durch baseninduzierte Dehydrohalogenierung, **dadurch gekennzeichnet, dass** die Umsetzung durch Polymerisation von Monomeren gemäß Formel (XXVI) 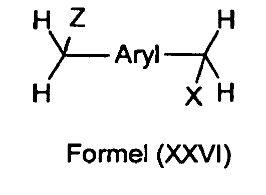 in Gegenwart von 0,1 - 80 mol% einer oder mehrerer Verbindungen gemäß Formel (I) durchgeführt wird: 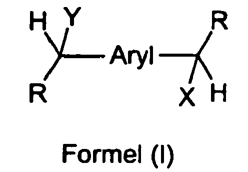 wobei die Symbole in Formeln (I), (la), (Ib) und (XXVI) die folgenden Bedeutungen haben:
Aryl ist bei jedem Auftreten gleich oder verschieden ein bivalentes aromatisches oder heteroaromatisches Ringsystem mit 2 bis 40 C-Atomen, welches mit Resten R¹ substituiert oder auch unsubstituiert sein kann, oder eine mit R¹ substituierte oder unsubstituierte Stilbenyleneinheit; dabei sind die beiden Substituenten CHXR und CHYR so angeordnet, dass eine gerade Anzahl aromatischer Atome dazwischen liegt; die Aryl- und Heteroaryl-Systeme können dabei auch Teil eines größeren kondensierten aromatischen Ringsystems sein; die möglichen Substituenten R¹ können potenziell an jeder freien Position sitzen;
R ist bei jedem Auftreten gleich oder verschieden eine Alkylkette mit 1 bis 40 C-Atomen, die geradkettig, verzweigt oder cyclisch sein kann, die außerdem mit einem oder mehreren Resten R¹ substituiert oder unsubstituiert sein kann, in der auch ein oder mehrere nicht benachbarte C-Atome durch -CR²=CR²-, -C≡C-, -NR²-, -O-, -S-, -CO-, -CO-O-, -CONR²-, -O-CO-O- ersetzt sein können, wobei auch ein oder mehrere H-Atome durch Fluor ersetzt sein können, ein aromatisches oder heteroaromatisches Ringsystem mit 2 bis 40 C-Atomen, welches mit R¹ substituiert oder unsubstituiert sein kann, eine mit R¹ substituierte oder unsubstituierte Stilbenyl- bzw. Tolanyleinheit, -Si(R²)₃, -N(R²)₂, -OR² oder eine Kombination dieser Systeme; die Aryl- und Heteroaryl-Systeme können dabei auch Teil eines größeren kondensierten aromatischen Ringsystems sein; die möglichen Substituenten können potenziell an jeder freien Position sitzen;
X ist bei jedem Auftreten gleich oder verschieden Cl, Br, I, Trifluormethansulfonat oder Arylsulfonat;
Y ist bei jedem Auftreten gleich oder verschieden Cl, Br, I, Trifluormethansulfonat, Arylsulfonat, -S(O)-R² oder R¹;
Z ist bei jedem Auftreten gleich oder verschieden Cl, Br, l, Trifluormethansulfonat, Arylsulfonat oder -S(O)R²;
R¹ ist bei jedem Auftreten gleich oder verschieden eine geradkettige, verzweigte oder cyclische Alkylkette mit 1 bis 40 C-Atomen, in der auch ein oder mehrere nicht benachbarte C-Atome durch -CR²=CR²-, -C≡C-, -NR²-, -O-, -S-, -CO-, -CO-O-, -CONR²-, -O-CO-O- ersetzt sein können, wobei auch ein oder mehrere H-Atome durch Fluor ersetzt sein können, ein aromatisches oder heteroaromatisches Ringsystem mit 2 bis 40 C-Atomen, welches auch durch ein oder mehrere nicht-aromatische Reste R¹ substituiert sein kann, eine substituierte oder unsubstituierte Vinylgruppe oder Cl, F, CN, N(R²)₂, B(R²)₂; die Aryl- und Heteroaryl-Systeme können dabei auch Teil eines größeren kondensierten aromatischen Ringsystems sein; die möglichen Substituenten können potenziell an jeder freien Position sitzen; dabei können auch zwei oder mehrere Reste R¹ miteinander ein Ringsystem bilden;
R² ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch -O-, -S-, -CO-O-, -O-CO-O- ersetzt sein können, wobei auch ein oder mehrere H-Atome durch Fluor ersetzt sein können, ein Aryl- oder Heteroaryl-System mit 2 bis 40 C-Atomen, welches auch durch ein oder mehrere nicht-aromatische R¹ substituiert sein kann; und
Poly für eine Anbindung zu einer Poly(arylenvinylen)-Hauptkette steht.

12. Poly(arylenvinylene) gemäß Anspruch 11, **dadurch gekennzeichnet, daß** der Rest Poly ein Poly(arylenvinylen) Homo- oder Copolymer ist, welches gegebenenfalls substituiert sein kann.

13. Verwendung von Poly(arylenvinylenen) gemäß Anspruch 11 und/oder 12 als Elektrolumineszenzmaterial in polymeren Leuchtdioden (PLEDs), in organischen integrierten Schaltungen (O-ICs), in organischen Feld-Effekt-Transistoren (OFETs), in organischen Dünnfilmtransistoren (OTFTs), in photorefraktiven Elementen, in organischen Solarzellen (O-SCs), organischen Leuchtdioden (OLED) oder organischen Laserdioden (O-Laser).

14. Elektronisches Bauteil enthaltend Kathode, Anode sowie eine oder mehrere aktive Schichten, wobei mindestens eine dieser aktiven Schichten ein oder mehrere Poly(arylenvinylene) gemäß Anspruch 11 und/oder 12 enthält.

15. Elektronisches Bauteil gemäß Anspruch 14, **dadurch gekennzeichnet, dass** es sich um polymere Leuchtdioden (PLEDs), organische integrierte Schaltungen (O-lCs), organische Feld-Effekt-Transistoren (OFETs), organische Dünnfilmtransistoren (OTFTs), organische Solarzellen (O-SCs), organische photorefraktive Elemente, organische Leuchtdioden (OLED) oder organische Laserdioden (O-Laser) handelt.

## Claims

1. Process for the preparation of poly(arylenevinylenes) from bis(halomethyl)-arylenes or halomethylsulfinylmethylarylenes by base-induced dehydrohalogenation, **characterised in that** the reaction is carried out in the presence of 0.1 - 80 mol% of one or more compounds of the formula (I): 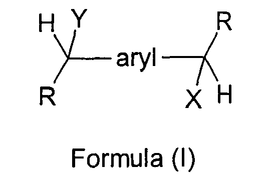 where the symbols have the following meanings:
aryl is on each occurrence, identically or differently, a divalent aromatic or heteroaromatic ring system having 2 to 40 C atoms, which may be substituted by radicals R¹ or also unsubstituted, or an R¹-substituted or unsubstituted stilbenylene unit; the two substituents CHXR and CHYR here are arranged in such a way that an even number of aromatic atoms lies in between; the aryl and heteroaryl systems here may also be part of a larger condensed aromatic ring system; the possible substituents R¹ can potentially be in any free position;
R is on each occurrence, identically or differently, an alkyl chain having 1 to 40 C atoms, which may be straight-chain, branched or cyclic and which, in addition, may be substituted by one or more radicals R¹ or unsubstituted and in which one or more non-adjacent C atoms may be replaced by -CR²=CR²-, -C≡C-, -NR²-, -O-, -S-, -CO-, -CO-O-, -CONR²-, -O-CO-O-, where, in addition, one or more H atoms may be replaced by fluorine, an aromatic or heteroaromatic ring system having 2 to 40 C atoms, which may be substituted by R¹ or unsubstituted, an R¹-substituted or unsubstituted stilbenyl or tolanyl unit, -Si(R²)₃, -N(R²)₂, -OR² or a combination of these systems; the aryl and heteroaryl systems here may also be part of a larger condensed aromatic ring system; the possible substituents can potentially be in any free position;
X is on each occurrence, identically or differently, Cl, Br, I, trifluoromethanesulfonate or arylsulfonate;
Y is on each occurrence, identically or differently, Cl, Br, I, trifluoromethanesulfonate, arylsulfonate, -S(O)-R² or R¹;
R¹ is on each occurrence, identically or differently, a straight-chain, branched or cyclic alkyl chain having 1 to 40 C atoms, in which, in addition, one or more non-adjacent C atoms may be replaced by -CR²=CR²-, -C≡C-, -NR²-, -O-, -S-, -CO-, -CO-O-, -CONR²-, -O-CO-O- and in which one or more H atoms may be replaced by fluorine, an aromatic or heteroaromatic ring system having 2 to 40 C atoms, which may also be substituted by one or more non-aromatic radicals R¹, a substituted or unsubstituted vinyl group or Cl, F, CN, N(R²)₂, B(R²)₂; the aryl and heteroaryl systems here may also be part of a larger condensed aromatic ring system; the possible substituents can potentially be in any free position; two or more radicals R¹ here may also form a ring system with one another;
R² is on each occurrence, identically or differently, H, a straight-chain, branched or cyclic alkyl chain having 1 to 22 C atoms, in which, in addition, one or more non-adjacent C atoms may be replaced by -O-, -S-, -CO-O-, -O-CO-O- and in which one or more H atoms may be replaced by fluorine, an aryl or heteroaryl system having 2 to 40 C atoms, which may also be substituted by one or more non-aromatic R¹.

2. Process according to Claim 1, **characterised in that** the halogen atoms in the bis-(halomethyl)arylene monomers or halomethylsulfinylmethylarylene monomers are, identically or differently, Cl, Br or I.

3. Process according to Claim 1 and/or 2, **characterised in that** the polymerisation is carried out in an ether, an aromatic hydrocarbon, a chlorinated aromatic compound or a mixture of these solvents if bis(halomethyl)arylene monomers are used or that the polymerisation is carried out in an ether, an aromatic hydrocarbon, a chlorinated aromatic or non-aromatic compound, DMSO, an alcohol or a mixture of these solvents if halomethylsulfinylmethylarylene monomers are used.

4. Process according to one or more of Claims 1 to 3, **characterised in that** the reaction is carried out in a concentration range from 0.005 to 5 mol/I (monomer/solution volume).

5. Process according to one or more of Claims 1 to 4, **characterised in that** the bases used are alkali metal hydroxides, alkali metal alkoxides or organic amines or amides, or also alkali metal hydrides or organometallic compounds if the solvent used is not DMSO, an alcohol or a chlorinated solvent.

6. Process according to one or more of Claims 1 to 5, **characterised in that** the amount of base employed is in the range from 2 to 10 equivalents (based on one equivalent of monomer) if the monomers employed are bis(halomethyl)aryl compounds and in the range from 1 to 10 equivalents (based on one equivalent of monomer) if the monomers employed are halomethylsulfinylmethylaryl compounds.

7. Process according to one or more of Claims 1 to 6, **characterised in that** between 2 and 40 mol% (based on the total amount of the remaining monomers) of one or more compounds of the formula (I) are added.

8. Process according to one or more of Claims 1 to 7, **characterised in that** the following applies to the compound of the formula (I):
aryl is on each occurrence, identically or differently, a divalent aromatic ring system having 2 to 40 C atoms, which may be substituted by up to 4 substituents R¹ or also unsubstituted, or an R¹-substituted or unsubstituted stilbenylene unit; the two substituents CHXR and CHYR here are arranged in such a way that an even number of aromatic atoms lies in between; the aryl system here may also be part of a larger condensed aromatic ring system; the possible substituents R¹ here can potentially be in any free position;
R is as defined in Claim 1;
X is on each occurrence, identically or differently, Cl, Br, I;
Y is as defined in Claim 1;
R¹, R² are as defined in Claim 1.

9. Process according to Claim 8, **characterised in that** the compound of the formula (I) is selected from the formulae (II) to (XXV), which may be substituted or unsubstituted:

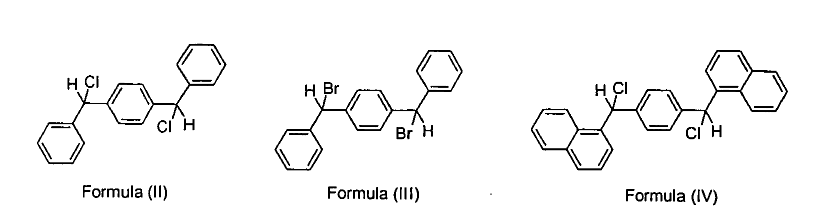

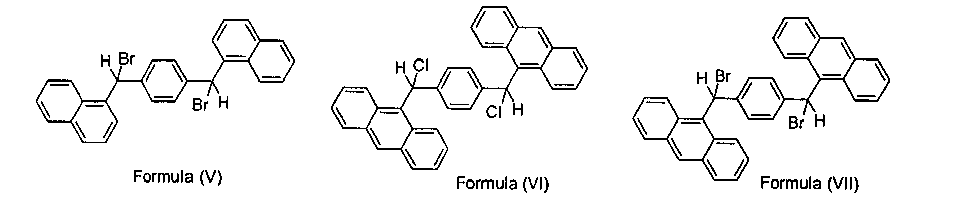

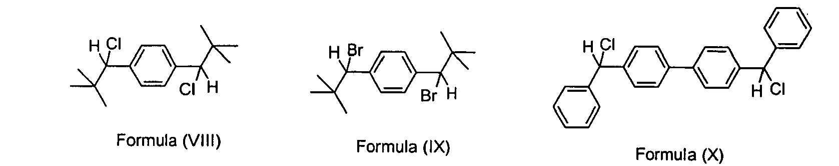

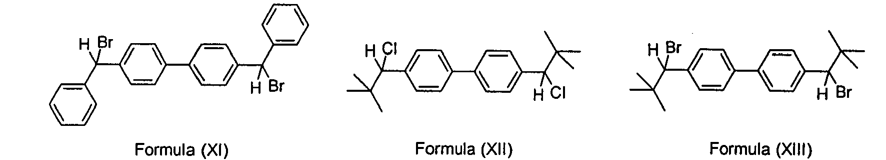

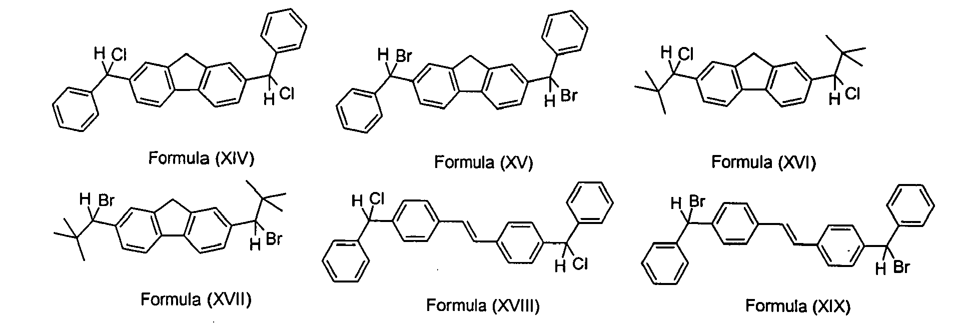

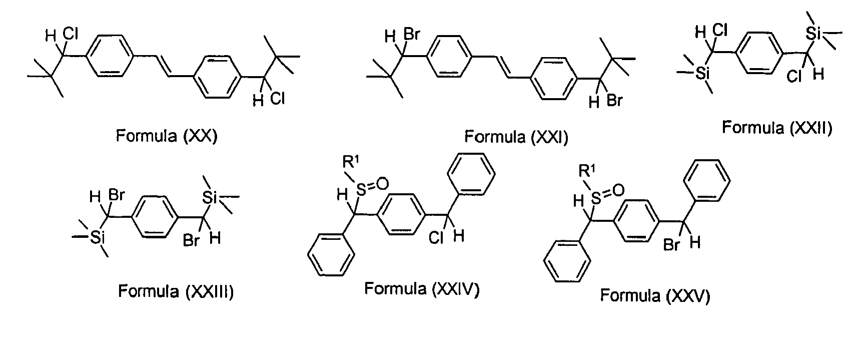

10. Process according to one or more of Claims 1 to 9, **characterised in that** the poly(aryleneethylene) precursor polymer that is obtained if the monomers employed are halomethylsulfinylmethylaryl compounds is converted into the conjugated poly-(arylenevinylene) by thermal treatment.

11. Poly(arylenevinylenes) containing at least 0.1 mol% of units of the formulae (Ia) and/or (Ib) 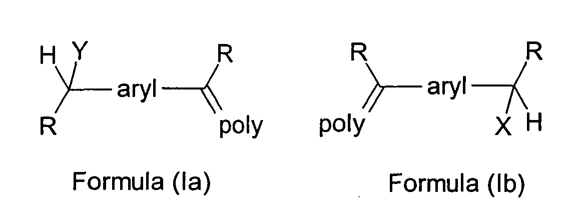 obtainable from bis(halomethyl)arylenes or halomethylsulfinylmethylarylenes by base-induced dehydrohalogenation, **characterised in that** the reaction is carried out by polymerisation of monomers of the formula (XXVI) 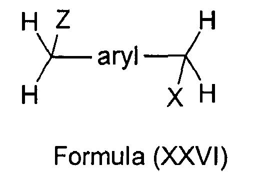 in the presence of 0.1 - 80 mol% of one or more compounds of the formula (I): 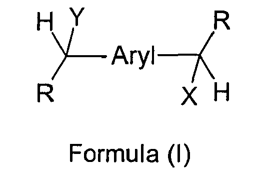 where the symbols in formulae (I), (Ia), (Ib) and (XXVI) have the following meanings:
aryl is on each occurrence, identically or differently, a divalent aromatic or heteroaromatic ring system having 2 to 40 C atoms, which may be substituted by radicals R¹ or also unsubstituted, or an R¹-substituted or unsubstituted stilbenylene unit; the two substituents CHXR and CHYR here are arranged in such a way that an even number of aromatic atoms lies in between; the aryl and heteroaryl systems here may also be part of a larger condensed aromatic ring system; the possible substituents R¹ can potentially be in any free position;
R is on each occurrence, identically or differently, an alkyl chain having 1 to 40 C atoms, which may be straight-chain, branched or cyclic and which, in addition, may be substituted by one or more radicals R¹ or unsubstituted and in which one or more non-adjacent C atoms may be replaced by -CR²=CR²-, -C≡C-, -NR²-, -O-, -S-, -CO-, -CO-O-, -CONR²-, -O-CO-O-, where, in addition, one or more H atoms may be replaced by fluorine, an aromatic or heteroaromatic ring system having 2 to 40 C atoms, which may be substituted by R¹ or unsubstituted, an R¹-substituted or unsubstituted stilbenyl or tolanyl unit, -Si(R²)₃, -N(R²)₂, -OR² or a combination of these systems; the aryl and heteroaryl systems here may also be part of a larger condensed aromatic ring system; the possible substituents can potentially be in any free position;
X is on each occurrence, identically or differently, Cl, Br, I, trifluoromethanesulfonate or arylsulfonate;
Y is on each occurrence, identically or differently, Cl, Br, l, trifluoromethanesulfonate, arylsulfonate, -S(O)-R² or R¹;
Z is on each occurrence, identically or differently, Cl, Br, I, trifluoromethanesulfonate, arylsulfonate or -S(O)R²;
R¹ is on each occurrence, identically or differently, a straight-chain, branched or cyclic alkyl chain having 1 to 40 C atoms, in which, in addition, one or more non-adjacent C atoms may be replaced by -CR²=CR²-, -C≡C-, -NR²-, -O-, -S-, -CO-, -CO-O-, -CONR²-, -O-CO-O- and in which one or more H atoms may be replaced by fluorine, an aromatic or heteroaromatic ring system having 2 to 40 C atoms, which may also be substituted by one or more non-aromatic radicals R¹, a substituted or unsubstituted vinyl group or Cl, F, CN, N(R²)₂, B(R²)₂; the aryl and heteroaryl systems here may also be part of a larger condensed aromatic ring system; the possible substituents can potentially be in any free position; two or more radicals R¹ here may also form a ring system with one another;
R² is on each occurrence, identically or differently, H, a straight-chain, branched or cyclic alkyl chain having 1 to 22 C atoms, in which, in addition, one or more non-adjacent C atoms may be replaced by -O-, -S-, -CO-O-, -O-CO-O- and in which one or more H atoms may be replaced by fluorine, an aryl or heteroaryl system having 2 to 40 C atoms, which may also be substituted by one or more non-aromatic R¹, and
poly stands for a bond to a poly(arylenevinylene) main chain.

12. Poly(arylenevinylenes) according to Claim 11, **characterised in that** the poly radical is a poly(arylenevinylene) homopolymer or copolymer, which may optionally be substituted.

13. Use of poly(arylenevinylenes) according to Claim 11 and/or 12 as electroluminescent material in polymeric light-emitting diodes (PLEDs), in organic integrated circuits (O-lCs), in organic field-effect transistors (OFETs), in organic thin-film transistors (OTFTs), in photorefractive elements, in organic solar cells (O-SCs), organic light-emitting diodes (OLEDs) or organic laser diodes (O-lasers).

14. Electronic component comprising cathode, anode and one or more active layers, where at least one of these active layers comprises one or more poly(arylenevinylenes) according to Claim 11 and/or 12.

15. Electronic component according to Claim 14, **characterised in that** it relates to polymeric light-emitting diodes (PLEDs), organic integrated circuits (O-ICs), organic field-effect transistors (OFETs), organic thin-film transistors (OTFT), organic solar cells (O-SCs), organic photorefractive elements, organic light-emitting diodes (OLEDs) or organic laser diodes (O-lasers).

## Revendications

1. Procédé pour la préparation de poly(arylènevinylènes) à partir de bis(halométhyl)arylènes ou d'halométhylsulfinylméthylarylènes au moyen d'une déshydrohalogénation induite par base, **caractérisé en ce que** la réaction est mise en oeuvre en présence de 0,1-80 mol% d'un ou de plusieurs composés de la formule (I) : 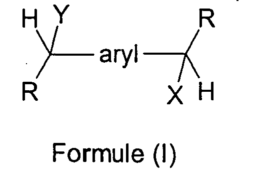 dans laquelle les symboles présentent les significations qui suivent :
aryl est, lors de chaque occurrence, de manière identique ou différente, un système d'anneau aromatique ou hétéroaromatique divalent comportant de 2 à 40 atomes de C, qui peut être substitué par des radicaux R¹ ou également non substitué, ou une unité de stilbénylène substitué R¹ ou non substitué ; les deux substituants CHXR et CHYR sont ici agencés de telle sorte qu'un nombre pair d'atomes aromatiques soient liés entre ; les systèmes aryle et hétéroaryle peuvent également être ici une partie d'un système d'anneau aromatique condensé plus grand ; les substituants possibles R¹ peuvent potentiellement être au niveau de n'importe quelle position libre;
R est, lors de chaque occurrence, de manière identique ou différente, une chaîne alkyle comportant de 1 à 40 atomes de C, qui peut être une chaîne droite, ramifiée ou cyclique et qui, en outre, peut être substituée par un ou plusieurs radicaux R¹ ou non substituée et où un ou plusieurs atomes de C non adjacents peuvent être remplacés par -CR²=CR²-, -C≡C-, -NR²-, -O-, -S-, -CO-, -CO-O-, -CONR²-, -O-CO-O-, où, en plus, un ou plusieurs atomes de H peuvent être remplacés par fluor, un système d'anneau aromatique ou hétéroaromatique comportant de 2 à 40 atomes de C, qui peut être substitué R¹ ou non substitué, une unité de stilbényle ou de tolanyle substituée R¹ ou non substituée, -Si(R²)₃, -N(R²)₂, -OR² ou une combinaison de ces systèmes, les systèmes aryle et hétéroaryle peuvent également ici être une partie d'un système d'anneau aromatique condensé plus grand ; les substituants possibles peuvent potentiellement être au niveau de n'importe quelle position libre ;
X est, lors de chaque occurrence, de manière identique ou différente, Cl, Br, I, trifluorométhanesulfonate ou arylsulfonate ;
Y est, lors de chaque occurrence, de manière identique ou différente, Cl, Br,l, trifluorométhanesulfonate, arylsulfonate, -S(O)-R² ou R¹ ;
R¹ est, lors de chaque occurrence, de manière identique ou différente, une chaîne droite, une chaîne alkyle ramifiée ou cyclique comportant de 1 à 40 atomes de C où, en plus, un ou plusieurs atomes de C non adjacents peuvent être remplacés par -CR²=CR²-, -C≡C-, -NR²-, -O-, -S-, -CO-, -CO-O-, -CONR²-, -O-CO-O- et où un ou plusieurs atomes de H peuvent être remplacés par fluor, un système d'anneau aromatique ou hétéroaromatique comportant de 2 à 40 atomes de C qui peut également être substitué par un ou plusieurs radicaux non aromatiques R¹, un groupe vinyle substitué ou non substitué ou Cl, F, CN, N(R²)₂, B(R²)₂ ; les systèmes aryle et hétéroaryle peuvent également ici être une partie d'un système d'anneau aromatique condensé plus grand ; les substituants possibles peuvent potentiellement être au niveau de n'importe quelle position libre ; deux radicaux R¹ ou plus peuvent ici également former un système d'anneau les uns avec les autres;
R² est, lors de chaque occurrence, de manière identique ou différente, H, une chaîne droite, une chaîne alkyle ramifiée ou cyclique comportant de 1 à 22 atomes de C où, en plus, un ou plusieurs atomes de C non adjacents peuvent être remplacés par -O-, -S-, -CO-O-, -O-CO-O- et où un ou plusieurs atomes de H peuvent être remplacés par fluor, un système aryle ou hétéroaryle comportant de 2 à 40 atomes de C, qui peut également être substitué par un ou plusieurs R¹ non aromatiques.

2. Procédé selon la revendication 1, **caractérisé en ce que** les atomes halogène dans les monomères bis(halométhyl)arylènes ou dans les monomères halométhylsulfinylméthylarylènes sont de manière identique ou différente Cl, Br ou I.

3. Procédé selon la revendication 1 et/ou 2, **caractérisé en ce que** la polymérisation est mise en oeuvre dans un éther, un hydrocarbure aromatique, un composé aromatique chloré ou un mélange de ses solvants si des monomères bis(halométhyl)arylènes sont utilisés ou la polymérisation est mise en oeuvre dans un éther, un hydrocarbure aromatique, un composé aromatique ou non aromatique chloré, du DMSO, un alcool ou un mélange de ces solvants si des monomères halométhylsulfinylméthylarylène sont utilisés.

4. Procédé selon l'une quelconque des revendications 1 à 3, **caractérisé en ce que** la réaction est mise en oeuvre dans une plage de concentrations de 0,005 à 5 mol/l (volume monomère/solution).

5. Procédé selon une ou plusieurs des revendications 1 à 4, **caractérisé en ce que** les bases utilisées sont des hydroxydes de métaux alcalins, des alkoxydes de métaux alcalins ou des amines ou amides organiques ou également des hydrures de métaux alcalins ou des composés organométalliques si le solvant utilisé n'est pas DMSO, un alcool ou un solvant chloré.

6. Procédé selon une ou plusieurs des revendications 1 à 5, **caractérisé en ce que** la quantité de base utilisée est dans la plage de 2 à 10 équivalents (sur la base d'un équivalent de monomère) si les monomères utilisés sont des composés bis-(halométhyl)arylènes et dans la plage de 1 à 10 équivalents (sur la base d'un équivalent de monomère) si les monomères utilisés sont des composés halométhylsulfinylméthylaryle.

7. Procédé selon une ou plusieurs des revendications 1 à 6, **caractérisé en ce que** entre 2 et 40 mol% (sur la base de la quantité totale des monomères restants) d'un ou de plusieurs composés de la formule (I) sont ajoutés.

8. Procédé selon une ou plusieurs des revendications 1 à 7, **caractérisé en ce** qui suit s'applique au composé de la formule (I) :
aryl est, lors de chaque occurrence, de manière identique ou différente, un système d'anneau aromatique divalent comportant de 2 à 40 atomes de C qui peut être substitué par jusqu'à quatre substituants R¹ ou également non substitué, ou une unité de stilbénylène substitué R¹ ou non substitué ; les deux substituants CHXR et CHYR sont ici agencés de telle sorte qu'un nombre pair d'atomes aromatiques soient liés entre ; le système aryle peut également être ici une partie d'un système d'anneau aromatique condensé plus grand ; les substituants possibles R¹ peuvent potentiellement être au niveau de n'importe quelle position libre;
R est comme défini selon la revendication 1;
X est, lors de chaque occurrence, de manière identique ou différente, Cl, Br, l ;
Y est comme défini selon la revendication 1 ;
R¹, R² sont comme défini selon la revendication 1.

9. Procédé selon la revendication 8, **caractérisé en ce que** le composé de la formule (I) est sélectionné parmi les formules (II) à (XXV), lequel peut être substitué ou non substitué :

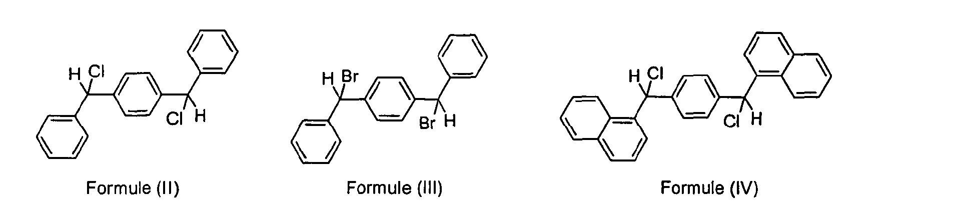

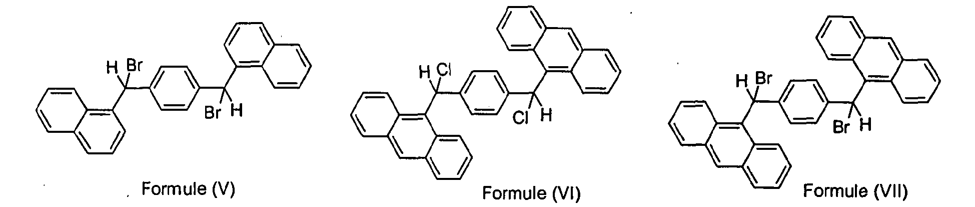

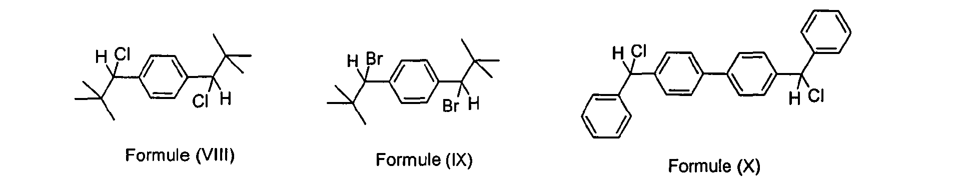

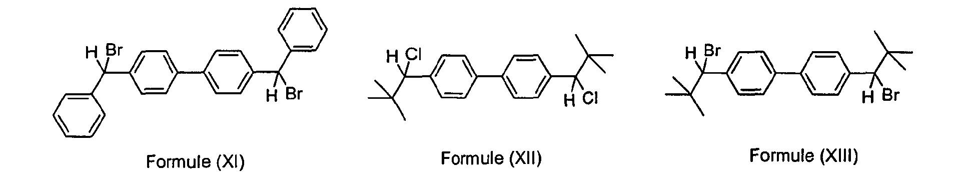

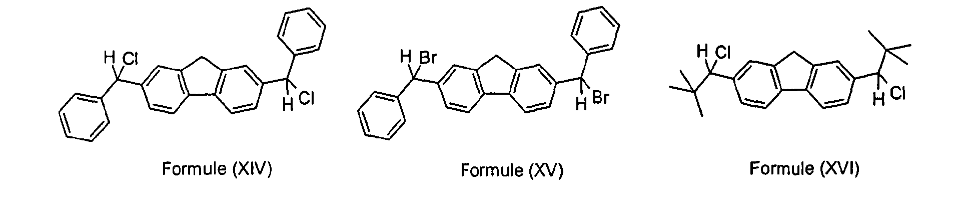

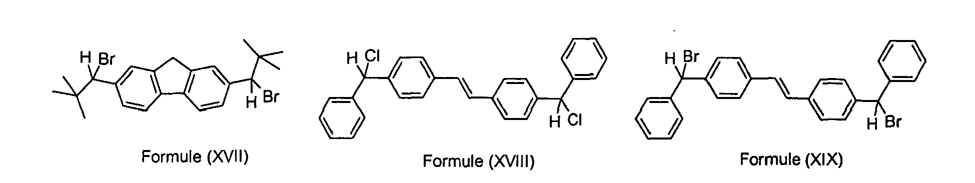

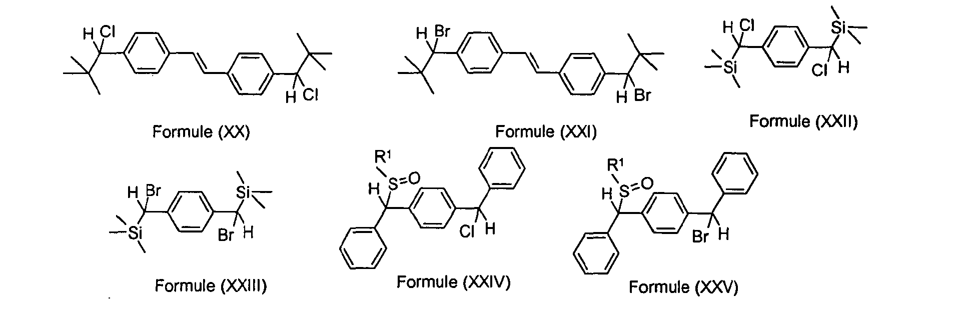

10. Procédé selon une ou plusieurs des revendications 1 à 9, **caractérisé en ce que** le polymère de précurseur poly(arylèneéthylène) qui est obtenu si les monomères utilisés sont des composés halométhylsulfinylméthylaryle est converti selon le poly(arylènevinylène) conjugué par traitement thermique.

11. Poly(arylènevinylènes) contenant au moins 0,1 mol% d'unités des formules (la) et/ou (Ib) : 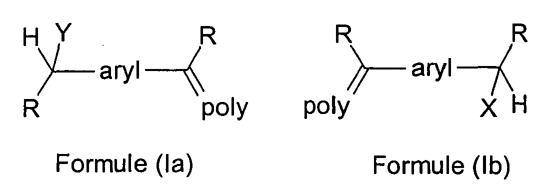 pouvant être obtenues à partir de bis(halométhyl)arylènes ou de halométhylsulfinylméthylarylènes par déshydrohalogénation induite par base, **caractérisés en ce que** la réaction est mise en oeuvre par polymérisation de monomères de la formule (XXVI): 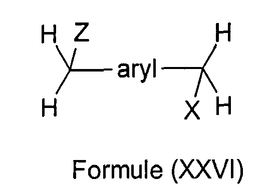 en présence de 0,1-80 mol% d'un ou de plusieurs composés de la formule (I): 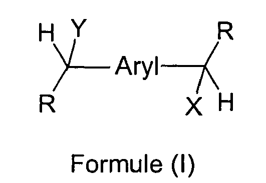 où les symboles au niveau des formules (I), (la), (Ib) et (XXVI) présentent les significations qui suivent :
Aryl est, lors de chaque occurrence, de manière identique ou différencte, un système d'anneau aromatique ou hétéroaromatique divalent comportant de 2 à 40 atomes de C, qui peut être substitué par des radicaux R¹ ou également non substitué, ou une unité de stilbenylène substitué R¹ ou non substitué les deux substituants CHXR et CHYR sont ici agencés de telle sorte qu'un nombre pair d'atome aromatiques soient liés entre ; les systèmes aryle et hétéroaryle peuvent également être ici une partie d'un système d'anneau aromatique condensé plus grand ; les substituants possibles R¹ peuvent potentiellement être au niveau de n'importe quelle position libre ;
R est, lors de chaque occurrence, de manière identique ou différente, une chaîne alkyle comportant de 1 a 40 atomes de C, qui peut être une chaîne droite, ramifié ou cyclique et qui, en outre, peut être substituée par un ou plusieurs radicaux R1 ou non substituée et où un ou plusieurs atomes de C non adjacents peuvent être remplacés par -CR²=CR², -C≡C-, -NR²-, -O-, -S-, -CO-, -CO-O-, -CONR²-, -O-CO-O-, où, en plus, un ou plusieurs atomes de H peuvent être remplacés par fluor, un systeme d'anneau aromatique ou hétéroaromatique comportant de 2 à 40 atomes de C, qui peut être substitué R¹ ou non substitué, une unité de stilbényle ou de tolanyle substituée R¹ ou non substituée, -Si(R²)₃, -N(R²)₂, -OR² ou une combinasion de ces systèmes, les systèmes aryle et hétéroaryle peuvent également ici être une partie d'un système d'anneau aromatique condensé plus grand ; les substituants possibles peuvent potentiellement être au niveau de n'importe quelle position libre ;
X est, lors de chaque occurrence, de manière identique ou différente, Cl, Br, l, trifluorométhanesulfonate ou arylsulfonate ;
Y est, lors de chaque occurrence, de manière identique ou différente, Cl, Br, l, trifluorométhanesulfonate, arylsulfonate, -S(O)-R² ou R¹ ;
Z est, lors de chaque occurrence, de manière identique ou différente, Cl, Br, l, trifluorométhanesulfonate, arylsulfonate ou -S(O)-R² ;
R¹ est, lors de chaque occurrence, de manière identique ou différente, une chaîne droite, une chaîne alkyle ralifiée ou cyclique comportant de 1 a 40 atomes de C où, en plus, un ou plusieurs atomes de C non adjacents peuvent être remplacés par -CR²=CR², -C≡C-, -NR²-, -O-, -S-, -CO-, -CO-O-, -CONR²-, -O-CO-O-, et où un ou plusieurs atomes de H peuvent être remplacés par fluor, un système d'anneau aromatique ou hétéroaromatique comportant de 2 a 40 atomes de C qui peut également être substitué ou non substitué ou Cl, F, CN, N(R²)₂, B(R²)₂ ; les systèmes aryles et hétéroaryle peuvent également ici être une partie d'un système d'anneau aromatique condensé plus grand; les substituants possibles peuvent potentiellement être au niveau de n'imprte quelle position libre; deux radicaux R¹ ou plus peuvent ici également former un système d'anneau les uns avec les autres ;
R² est, lors de chaque occurrence, de manière identique ou différente, H une chaîne droite, une chaîne alkyle ramifiée ou cyclique comportant de 1 a 22 atomes de C où, en plus, un ou plusieurs atomes de C non adjacents peuvent être remplacés par -O-, -S-, -CO-O-, -O-CO-O- et où un ou plusieurs atomes de H peuvent être remplacés par fluor, un système aryle ou hétéroaryle comportant de 2 a 40 atomes de C, qui peut également être substitué par un ou plusieurs R¹ non aromatiques ; et
poly représente une liaison sur une chaîne principale poly(arylènevinylène).

12. Poly(arylènevinylènes) selon la revendication 11, **caractérisés en ce que** le radical poly est un homopolymère ou copolymère poly(arylènevinylène) qui peut être en option substitué.

13. Utilisation de poly(arylènevinylènes) selon la revendication 11 et /ou 12 en tant que matériau électroluminescent dans des diodes émettrices de lumière polymériques (PDEL), dans des circuits intégrés organiques (O-IC), dans des transistors à effet de champ organiques (OFET), dans des transistors à film mince organiques (OTFT), dans des éléments photoréfractifs, dans des cellules solaires organiques (O-CS), dans des diodes émettrices de lumière organiques (DELO) ou dans des diodes laser organiques (O-lasers).

14. Composant électronique comprenant une cathode, une anode et une ou plusieurs couches actives, où au moins l'une de ces couches actives comprend un ou plusieurs poly(arylènevinylènes) selon la revendication 11 et/ou 12.

15. Composant électronique selon la revendication 14, **caractérisé en ce qu'**il concerne des diodes émettrices de lumière polymériques (PDEL), des circuits intégrés organiques (O-IC), des transistors à effet de champ organiques (OFET), des transistors à film mince organiques (OTFT), des cellules solaires organiques (O-CS), des éléments photoréfractifs organiques, des diodes émettrices de lumière organiques (DELO) ou des diodes laser organiques (O-lasers).
